# EUROPEAN PATENT APPLICATION

(11) **EP 4 365 945 A1**
(43) Date of publication of application: **08.05.2024**
(21) Application number: 23200658.5
(22) Date of filing: 28.09.2023
(51) Int. Cl.: H01L 23/538

(54) **ELECTRONIC DEVICE**

(30) Priority: 27.10.2022 US 202263419718 P; 26.07.2023 CN 202310924110
(71) Applicant: InnoLux Corporation, Chu-Nan, Miao-Li 350 (TW)
(72) Inventor: KAO, Ker-Yih, 350 Miao-Li County (TW); HUANG, Chin-Ming, 350 Miao-Li County (TW); CHENG, Wei-Yuan, 350 Miao-Li County (TW); YUEH, Jui-Jen, 350 Miao-Li County (TW); LEE, Kuan-Feng, 350 Miao-Li County (TW)
(74) Representative: Straus, Alexander

(57) **Abstract**

An electronic device (ED) includes an electronic element (EL), an encapsulation layer (EN) surrounding the electronic element (EL), a first circuit structure (CL1), a second circuit structure (CL2) and a connecting structure (CS). The encapsulation layer (EN) has a top surface (S1), a bottom surface (S2) and an opening (OP), wherein a sidewall (SW) of the opening (OP) connects the top surface (S1) and the bottom surface (S2). The first circuit structure (CL1) is disposed at the top surface (S1) of the encapsulation layer (EN). The second circuit structure (CL2) is disposed at the bottom surface (S2) of the encapsulation layer (EN). The connecting structure (CS) is disposed in the opening (OP). The connecting structure (CS) includes a first sub layer (SL1) and a second sub layer (SL2), and the first sub layer (SL1) is located between the encapsulation layer (EN) and the second sub layer (SL2).

## Description

### Field of the Disclosure

The present disclosure relates to an electronic device, and more particularly to an electronic device including package structure.

### Background of the Disclosure

The traditional quad flat no leads (QFN) package structure is formed by disposing the chip on a lead frame and electrically connecting the chip to the conductive pads on the lead frame. However, the QFN package structure has a higher production cost or a greater thickness. Therefore, to reduce the production cost or the entire thickness of the QFN package is still an important issue in the present field.

### Summary of the Disclosure

This is in mind, the present disclosure aims at providing an electronic device.

This is achieved by an electronic device according to the claims. The dependent claims pertain to corresponding further developments and improvements.

As will be seen more clearly from the detailed description following below, an electronic device is provided by the present disclosure. The electronic device includes at least one electronic element, an encapsulation layer surrounding the at least one electronic element, a first circuit structure, a second circuit structure and a connecting structure. The encapsulation layer has a top surface, a bottom surface and at least one opening, wherein a sidewall of the at least one opening connects the top surface and the bottom surface. The first circuit structure is disposed at the top surface of the encapsulation layer. The second circuit structure is disposed at the bottom surface of the encapsulation layer. The connecting structure is disposed in the at least one opening, wherein the at least one electronic element is electrically connected to the second circuit structure through the first circuit structure and the connecting structure. The connecting structure includes a first sub layer and a second sub layer, the first sub layer is located between the encapsulation layer and the second sub layer, and the first sub layer covers the sidewall of the at least one opening.

As will be seen more clearly from the detailed description following below, an electronic device is provided by the present disclosure. The electronic device includes at least one electronic element, an encapsulation layer surrounding the at least one electronic element, a first circuit structure, a second circuit structure and a connecting structure. The encapsulation layer has a top surface, a bottom surface and at least one opening, wherein a sidewall of the at least one opening connects the top surface and the bottom surface. The first circuit structure is disposed at the top surface of the encapsulation layer. The second circuit structure is disposed at the bottom surface of the encapsulation layer. The connecting structure is disposed in the at least one opening, wherein the at least one electronic element is electrically connected to the second circuit structure through the first circuit structure and the connecting structure.

As will be seen more clearly from the detailed description following below, a manufacturing method of an electronic device is provided by the present disclosure. The method includes providing an electronic element; forming an encapsulation layer surrounding the electronic element, wherein the encapsulation layer has a top surface and a bottom surface; forming at least one opening in the encapsulation layer, wherein the at least one opening connects the top surface and the bottom surface; disposing a first circuit structure at the top surface of the encapsulation layer; disposing a second circuit structure at the bottom surface of the encapsulation layer; and forming a connecting structure in the opening, wherein the electronic element is electrically connected to the second circuit structure through the first circuit structure and the connecting structure. The connecting structure includes a first sub layer and a second sub layer, the first sub layer is located between the encapsulation layer and the second sub layer, and the first sub layer covers the sidewall of the at least one opening.

### Brief Description of the Drawings

In the following, the disclosure is further illustrated by way of example, taking reference to the accompanying drawings. Thereof:
FIG. 1 schematically illustrates a cross-sectional view of an electronic device according to a first embodiment of the present disclosure;
FIG. 2 schematically illustrates a cross-sectional view of an electronic device according to a variant embodiment of the first embodiment of the present disclosure;
FIG. 3A to FIG. 3F schematically illustrate the manufacturing process of the electronic device according to the first embodiment of the present disclosure;
FIG. 4 schematically illustrates a top view of an electronic device according to a second embodiment of the present disclosure;
FIG. 5 schematically illustrates a cross-sectional view of the electronic device according to the second embodiment of the present disclosure;
FIG. 6A to FIG. 6G schematically illustrate the manufacturing process of the electronic device according to the second embodiment of the present disclosure;
FIG. 7A to FIG. 7B schematically illustrate the manufacturing process of the electronic device according to a variant embodiment of the second embodiment of the present disclosure;
FIG. 8 schematically illustrates a cross-sectional view of an electronic device according to a third embodiment of the present disclosure;
FIG. 9A to FIG. 9C schematically illustrate the manufacturing process of an electronic device according to a third embodiment of the present disclosure;
FIG. 10 schematically illustrates a cross-sectional view of an electronic device according to a fourth embodiment of the present disclosure;
FIG. 11A to FIG. 11C schematically illustrate the manufacturing process of an electronic device according to a fourth embodiment of the present disclosure;
FIG. 12 schematically illustrates a cross-sectional view of an electronic device according to a fifth embodiment of the present disclosure;
FIG. 13A to FIG. 13C schematically illustrate the manufacturing process of an electronic device according to a sixth embodiment of the present disclosure;
FIG. 14A to FIG. 14C schematically illustrate the manufacturing process of an electronic device according to a seventh embodiment of the present disclosure; and
FIG. 15A to FIG. 15D schematically illustrate the manufacturing process of an electronic device according to an eighth embodiment of the present disclosure.

### Detailed Description

The present disclosure may be understood by reference to the following detailed description, taken in conjunction with the drawings as described below. It is noted that, for purposes of illustrative clarity and being easily understood by the readers, various drawings of this disclosure show a portion of the device, and certain elements in various drawings may not be drawn to scale. In addition, the number and dimension of each element shown in drawings are only illustrative and are not intended to limit the scope of the present disclosure.

Certain terms are used throughout the description and following claims to refer to particular elements. As one skilled in the art will understand, electronic equipment manufacturers may refer to an element by different names. This document does not intend to distinguish between elements that differ in name but not function.

In the following description and in the claims, the terms "include", "comprise" and "have" are used in an open-ended fashion, and thus should be interpreted to mean "include, but not limited to...".

It will be understood that when an element or layer is referred to as being "disposed on" or "connected to" another element or layer, it can be directly on or directly connected to the other element or layer, or intervening elements or layers may be presented (indirectly). In contrast, when an element is referred to as being "directly on" or "directly connected to" another element or layer, there are no intervening elements or layers presented. When an element or a layer is referred to as being "electrically connected" to another element or layer, it can be a direct electrical connection or an indirect electrical connection. The electrical connection or coupling described in the present disclosure may refer to a direct connection or an indirect connection. In the case of a direct connection, the ends of the elements on two circuits are directly connected or connected to each other by a conductor segment. In the case of an indirect connection, switches, diodes, capacitors, inductors, resistors, other suitable elements or combinations of the above elements may be included between the ends of the elements on two circuits, but not limited thereto.

Although terms such as first, second, third, etc., may be used to describe diverse constituent elements, such constituent elements are not limited by the terms. The terms are used only to discriminate a constituent element from other constituent elements in the specification. The claims may not use the same terms, but instead may use the terms first, second, third, etc. with respect to the order in which an element is claimed. Accordingly, in the following description, a first constituent element may be a second constituent element in a claim.

According to the present disclosure, the thickness, length and width may be measured through optical microscope, and the thickness or width may be measured through the cross-sectional view in the electron microscope, but not limited thereto.

In addition, any two values or directions used for comparison may have certain errors. In addition, the terms "equal to", "equal", "the same", "approximately" or "substantially" are generally interpreted as being within ± 20%, ± 10%, ± 5%, ± 3%, ± 2%, ± 1%, or ± 0.5% of the given value.

In addition, the terms "the given range is from a first value to a second value" or "the given range is located between a first value and a second value" represents that the given range includes the first value, the second value and other values there between.

If a first direction is said to be perpendicular to a second direction, the included angle between the first direction and the second direction may be located between 80 to 100 degrees. If a first direction is said to be parallel to a second direction, the included angle between the first direction and the second direction may be located between 0 to 10 degrees.

Unless it is additionally defined, all terms (including technical and scientific terms) used herein have the same meaning as commonly understood by those ordinary skilled in the art. It can be understood that these terms that are defined in commonly used dictionaries should be interpreted as having meanings consistent with the relevant art and the background or content of the present disclosure, and should not be interpreted in an idealized or overly formal manner, unless it is specifically defined in the embodiments of the present disclosure.

It should be noted that the technical features in different embodiments described in the following can be replaced, recombined, or mixed with one another to constitute another embodiment without departing from the spirit of the present disclosure.

The electronic device of the present disclosure may include a package device, a display device, a sensing device, a back-light device, an antenna device, a tiled device, a power source management device or other suitable electronic devices, but not limited thereto. The electronic device of the present disclosure may include any suitable device applied to the above-mentioned devices. The electronic device may be a foldable electronic device, a flexible electronic device or a stretchable electronic device. The display device may for example be applied to laptops, common displays, tiled displays, vehicle displays, touch displays, televisions, monitors, smart phones, tablets, light source modules, lighting devices or electronic devices applied to the products mentioned above, but not limited thereto. The sensing device may include a biosensor, a touch sensor, a fingerprint sensor, other suitable sensors or combinations of the above-mentioned sensors. The antenna device may for example include a liquid crystal antenna device or a non-liquid crystal antenna device, but not limited thereto. The tiled device may for example include a tiled display device or a tiled antenna device, but not limited thereto. The outline of the electronic device may be a rectangle, a circle, a polygon, a shape with curved edge or other suitable shapes. The electronic device may include electronic units, wherein the electronic units may include passive elements or active elements, such as capacitor, resistor, inductor, diode, transistor, sensors, and the like. The diode may include a light emitting diode or a photo diode. The light emitting diode may for example include an organic light emitting diode (OLED) or an in-organic light emitting diode. The in-organic light emitting diode may for example include a mini light emitting diode (mini LED), a micro light emitting diode (micro LED) or a quantum dot light emitting diode (QLED), but not limited thereto. The electronic device may include a semiconductor package device. It should be noted that the electronic device of the present disclosure may be combinations of the above-mentioned devices, but not limited thereto. It should be noted that the electronic device may be arrangements of the above-mentioned devices, but the present disclosure is not limited thereto. The electronic device may include peripheral systems such as driving systems, controlling systems, light source systems to support display devices, antenna devices, wearable devices (such as augmented reality devices or virtual reality devices), vehicle devices (such as windshield of car) or tiled devices.

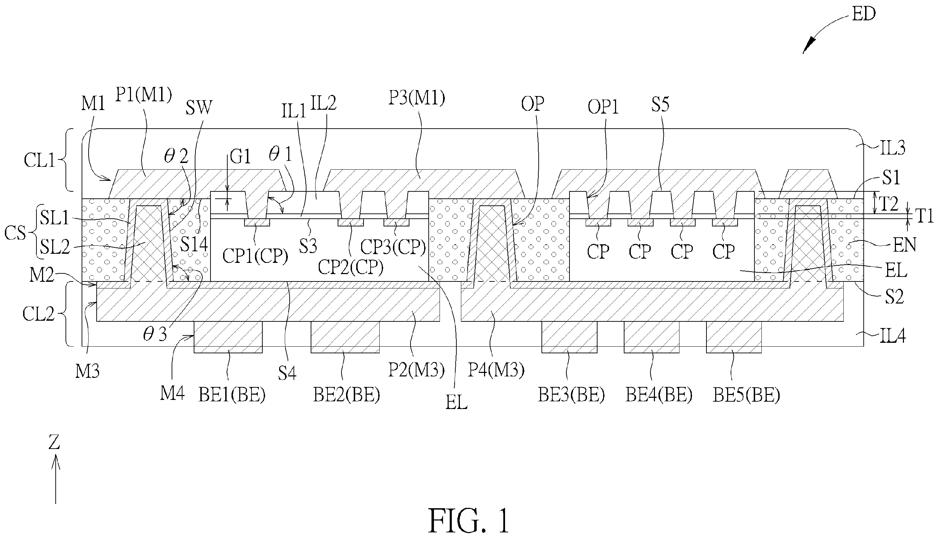

Referring to FIG. 1, FIG. 1 schematically illustrates a cross-sectional view of an electronic device according to a first embodiment of the present disclosure. According to the present embodiment, as shown in FIG. 1, the electronic device ED includes electronic elements EL, an encapsulation layer EN surrounding the electronic elements EL, a first circuit structure CL1, a second circuit structure CL2 and a connecting structure CS, but not limited thereto. The encapsulation layer EN has a top surface S 1 and a bottom surface S2 opposite to the top surface S 1, wherein the first circuit structure CL1 is disposed at the top surface S 1 of the encapsulation layer EN, and the second circuit structure CL2 is disposed at the bottom surface S2 of the encapsulation layer EN. In other words, the first circuit structure CL1 and the second circuit structure CL2 are respectively be disposed at two sides of the encapsulation layer EN. The encapsulation layer EN has an opening OP, and the sidewall SW of the opening OP connects the top surface S1 and the bottom surface S2, wherein the connecting structure CS is disposed in the opening OP. The structure of the elements of the electronic device ED of the present embodiment will be detailed in the following.

The electronic element EL may include any suitable active element or passive element. For example, the electronic element EL may include printed circuit board (PCB), integrated circuit (IC), diode, resistor, capacitor, other suitable electronic elements or combinations of the above-mentioned electronic elements. The type of the electronic element EL may be determined according to the type of the electronic device ED. In some embodiments, the electronic device ED may include the display device, and the electronic element EL may include light emitting diode chip, but not limited thereto. The electronic element EL may be the chip including one or more kinds of elements. In the present embodiment, the electronic device ED may include at least one electronic element EL. For example, FIG. 1 shows the structure that the electronic device ED includes two electronic elements EL, but not limited thereto. It should be noted that according to the design or use of the electronic device ED, the types of the electronic elements EL in the electronic device ED may be the same or different. The electronic element EL may include at least one conductive pad CP, wherein the conductive pad CP may be located at a side of the electronic element EL. The conductive pads CP of the electronic element EL may be electrically connected to other conductive elements. In the present embodiment, the numbers of the conductive pads CP of different electronic elements EL may be the same or different. According to some embodiments, the sizes of the conductive pads CP of different electronic elements EL may be the same or different. For example, in a cross-sectional view of the electronic device ED, the widths of the conductive pads CP may be the same or different. The conductive pads CP may include any suitable conductive materials, such as copper (Cu), aluminum (Al), nickel (Ni), molybdenum (Mo), titanium (Ti), alloys of the above-mentioned materials, combinations of the above-mentioned materials or other suitable materials, but not limited thereto. In the present disclosure, the above-mentioned "width" may for example be measured along a direction perpendicular to the direction Z.

The electronic device ED may further include a first insulating layer IL1, wherein the first insulating layer IL1 may be disposed at a side of the electronic element EL. Specifically, the first insulating layer IL1 may be disposed on a surface at a side of the electronic element EL corresponding to the conductive pads CP of the electronic element EL. For example, as shown in FIG. 1, the conductive pads CP of the electronic element EL may be located on the top surface S3 of the electronic element EL, and the first insulating layer IL1 may be disposed on the top surface S3 of the electronic element EL, but not limited thereto. The first insulating layer IL1 may serve as the passivation layer of the electronic element EL. The first insulating layer IL1 may include inorganic insulating materials such as silicon oxide or silicon nitride, but not limited thereto.

The electronic device ED may further include a second insulating layer IL2, wherein the second insulating layer IL2 may be disposed at a side of the first insulating layer IL1 opposite to the electronic element EL. For example, the second insulating layer IL2 may be disposed on the first insulating layer IL1, but not limited thereto. In other words, the first insulating layer IL1 may be disposed between the second insulating layer IL2 and the electronic element EL. The second insulating layer IL2 may cover the first insulating layer II,1. The second insulating layer IL2 may include any suitable organic materials, such as Ajinomoto build-up (ABF) film or polyimide, but not limited thereto. In the present embodiment, the elastic coefficient of the second insulating layer IL2 may be greater than the elastic coefficient of the first insulating layer IL 1.

In the present embodiment, the first insulating layer IL1 has a thickness T1, and the second insulating layer IL2 has a thickness T2, wherein the thickness T2 may be greater than the thickness T1. The thickness T1 of the first insulating layer IL1 may range from 0.5 micrometers (µm) to 3µm, and the thickness T2 of the second insulating layer IL2 may range from 5µm to 25µm, but not limited thereto. Since the elastic coefficient of the material of the second insulating layer IL2 may be greater than the elastic coefficient of the material of the first insulating layer IL1, or the thickness T2 of the second insulating layer IL2 may be greater than the thickness T1 of the first insulating layer IL1, the second insulating layer IL2 may provide protection to reduce the possibility of breakage of the first insulating layer IL1 during the manufacturing process (such as the cutting process) of the electronic device ED. In detail, when the elastic coefficient of the second insulating layer IL2 is greater than the elastic coefficient of the first insulating layer IL1, the second insulating layer IL2 may absorb or reduce the stress on the electronic device ED during the cutting process, thereby reducing the risk of breakage of the electronic elements EL. For example, electrical abnormal caused by chipping may be reduced, or the influence of chipping on the subsequent processes may be reduced, but not limited thereto. According to some embodiments, the coefficient of thermal expansion of the second insulating layer IL2 may be greater than the coefficient of thermal expansion of the first insulating layer IL1, or the tendency of thermal expansion of the first insulating layer IL1 may be opposite to the tendency of thermal expansion of the second insulating layer IL2, thereby reducing the warpage of the electronic device ED.

The encapsulation layer EN may surround the electronic element EL and encapsulate the electronic element EL. Specifically, the encapsulation layer EN may surround the electronic element EL and the first insulating layer IL1 and the second insulating layer IL2 disposed on the electronic element EL. In the present embodiment, "an element surrounds another element" may represent that the element at least partially contacts the side surface of the another element in a cross-sectional view of the electronic device ED. For example, as shown in FIG. 1, the encapsulation layer EN may contact the side surfaces of the electronic element EL, the first insulating layer IL1 and the second insulating layer IL2. The encapsulation layer EN may provide the waterproof effect of the electronic element EL, thereby improving the reliability of the electronic device ED. The encapsulation layer EN may include any suitable encapsulating material, such as epoxy molding compound (EMC), but not limited thereto.

In the present embodiment, the top surface S1 of the encapsulation layer EN may be adjacent to a side of the electronic element EL where the conductive pads CP are located, and the bottom surface S2 may be another surface of the encapsulation layer EN opposite to the top surface S1. The surface of the electronic element EL where the conductive pads CP are disposed (that is, the top surface S3) may be regarded as the active surface of the electronic element EL, and the surface of the electronic element EL opposite to the active surface (that is, the bottom surface S4) may be regarded as the non-active surface (or the rear surface) of the electronic element EL. In other words, the top surface S1 of the encapsulation layer EN may be adjacent to the active surface of the electronic element EL, and the bottom surface S2 of the encapsulation layer EN may be adjacent to the non-active surface of the electronic element EL. The first insulating layer IL1 and the second insulating layer IL2 may be disposed on the active surface of the electronic element EL. In the present embodiment, the top surface S1 of the encapsulation layer EN may be aligned with the top surface S5 of the second insulating layer IL2, and the bottom surface S2 of the encapsulation layer EN may be aligned with the rear surface (that is, the bottom surface S4) of the electronic element EL, but not limited thereto. In other words, the encapsulation layer EN may expose the top surface S5 of the second insulating layer IL2 and the rear surface of the electronic element EL.

The encapsulation layer EN may have at least one opening OP, the opening OP may penetrate the encapsulation layer EN, wherein the opening OP may be formed by removing a portion of the encapsulation layer EN. Therefore, the sidewall SW of the opening OP may connect the top surface S1 and the bottom surface S2 of the encapsulation layer EN. In the present embodiment, the opening OP may not overlap the electronic element EL, the first insulating layer IL1 and the second insulating layer IL2 in the normal direction (that is, the direction Z) of the electronic device ED. In other words, the electronic element EL, the first insulating layer IL1 and the second insulating layer IL2 may not be removed in the forming process of the opening OP. The opening OP may have a trapezoidal shape in a cross-sectional view of the electronic device ED, but not limited thereto. In other words, the width of the top of the opening OP and the width of the bottom of the opening OP may be different. According to some embodiments, an included angle θ2 may be included between the sidewall SW of the opening OP and the top surface S1 of the encapsulation layer EN, and an included angle θ3 may be included between the sidewall SW of the opening OP and the bottom surface S2 of the encapsulation layer EN, wherein the included angle θ2 and the included angle θ3 may be the same or different. The included angle θ2 and the included angle θ3 may range from 65 degrees to 135 degrees, but not limited thereto.

The first circuit structure CL1 may be disposed at the top surface S1 of the encapsulation layer EN. Specifically, the first circuit structure CL1 may be disposed on the top surface S1 of the encapsulation layer EN. The first circuit structure CL1 may include any suitable structure formed by stacking insulating layer(s) and conductive layer(s), wherein the stacking direction of the insulating layer(s) and the conductive layer(s) may be parallel to the normal direction of the electronic device ED. For example, as shown in FIG. 1, the first circuit structure CL1 may include a first conductive layer M1 and an insulating layer IL3 disposed on the first conductive layer M1 and covering the first conductive layer M1, but not limited thereto. In some embodiments, the first circuit structure CL1 may include a structure formed by stacking more conductive layers and insulating layers. In the present embodiment, a conductive layer (for example, the first conductive layer M1 of the first circuit structure CL1, but not limited thereto) in the first circuit structure CL1 may be directly disposed on the top surface S1 of the encapsulation layer EN or may contact the top surface S1. The conductive layer(s) (such as the first conductive layer M1) of the first circuit structure CL1 may include any suitable conductive material, such as copper, titanium, nickel, alloys of the above-mentioned materials or combinations of the above-mentioned materials, but not limited thereto. The insulating layer(s) (such as the insulating layer IL3) in the first circuit structure CL1 may include any suitable insulating material, such as build up film, polyimide, epoxy, silicon dioxide, silicon nitride, solder resist or combinations of the above-mentioned materials, but not limited thereto. In the present embodiment, the corners of the insulating layer IL3 at a side opposite to the electronic element EL may be curved or include other suitable non-sharp shapes, but not limited thereto.

According to the present embodiment, the first circuit structure CL1 may be electrically connected to the electronic element EL. Specifically, the first conductive layer M1 extending on the top surface S1 of the encapsulation layer EN may pass through the openings OP1 in the first insulating layer IL1 and the second insulating layer IL2 to be electrically connected to the conductive pads CP of the electronic element EL, such that the electronic element EL may be electrically connected to the first circuit structure CL1. In detail, a portion of the first insulating layer IL1 and a portion of the second insulating layer IL2 may be removed to form the openings OP1, wherein the openings OP1 may correspond to the conductive pads CP of the electronic element EL, or the openings OP1 may at least partially overlap the conductive pads CP in the normal direction of the electronic device ED. In such condition, the openings OP1 may expose the conductive pads CP. Therefore, the first conductive layer M1 may be filled into the openings OP1 and directly contact the conductive pads CP, such that the electronic element EL may be electrically connected to the first circuit structure CL1. The opening OP1 may have a trapezoidal shape in a cross-sectional view of the electronic device ED, but not limited thereto. Specifically, an included angle θ1 may be included between the sidewall of the opening OP1 (or the sidewall of the portion of the first conductive layer M1 filled into the opening OP1) and the surface of the first insulating layer IL1, wherein the included angle θ1 may range from 65 degrees to 85 degrees, but not limited thereto. In addition, in the present embodiment, the portion of the first conductive layer M1 not overlapped with the electronic element EL may contact the side surface of the second insulating layer IL2, or in other words, the bottom surface S14 of the portion of the first conductive layer M1 may be lower than the top surface S5 of the second insulating layer IL2. In such condition, a gap G1 may be included between the bottom surface S14 of the first conductive layer M1 and the top surface S5 of the second insulating layer IL2. According to the present embodiment, the gap G1 may for example range from 2µm to 10µm, but not limited thereto. Through the above-mentioned design, the degree of embedment between the elements (such as the first conductive layer M1 and the electronic element EL) may be improved, thereby improving the bonding strength. It should be noted that the way of electrically connecting the first circuit structure CL1 and the electronic element EL mentioned above is just exemplary, and the present disclosure is not limited thereto. According to some embodiments, the sizes of the openings OP1 corresponding to different electronic elements EL may be the same or different. For example, in a cross-sectional view of the electronic device ED, the widths of the openings OP1 corresponding to different electronic elements EL may be the same or different. In other words, when the electronic device ED includes a plurality of electronic elements EL, the width or the height of an opening OP1 corresponding to an electronic element EL may be greater than the width or the height of another opening OP1 corresponding to another electronic element EL, or, the width or the height of an opening OP1 corresponding to an electronic element EL may be the same as the width or the height of another opening OP1 corresponding to another electronic element EL.

In the present embodiment, the first conductive layer M1 of the first circuit structure CL1 may overlap the openings OP of the encapsulation layer EN in the normal direction of the electronic device ED, or the first conductive layer M1 may cover the openings OP. Therefore, the first circuit structure CL1 may be electrically connected to the second circuit structure CL2 through the connecting structure CS in the opening OP (which will be detailed in the following).

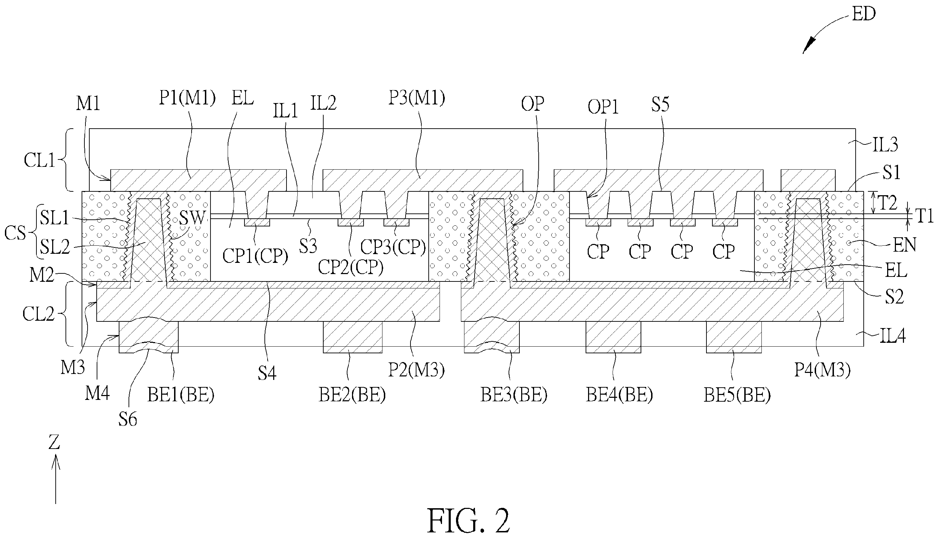

The second circuit structure CL2 may be disposed at the bottom surface S2 of the encapsulation layer EN. Specifically, the second circuit structure CL2 may be disposed under the bottom surface S2 of the encapsulation layer EN. In other words, the encapsulation layer EN and the electronic elements EL may be disposed between the first circuit structure CL1 and the second circuit structure CL2. Similar to the first circuit structure CL1, the second circuit structure CL2 may include any suitable structure formed by stacking insulating layer(s) and conductive layer(s), wherein the stacking direction of the insulating layer(s) and the conductive layer(s) may be parallel to the normal direction of the electronic device ED. For example, as shown in FIG. 1, the second circuit structure CL2 may include a second conductive layer M2, a conductive layer M3, a conductive layer M4 and an insulating layer IL4, but not limited thereto. The conductive layer M3 may be located under the second conductive layer M2. The conductive layer M4 may be located under the conductive layer M3. The insulating layer IL4 may surround the second conductive layer M2, the conductive layer M3 and the conductive layer M4. In some embodiments, the second circuit structure CL2 may include other suitable structures formed by stacking insulating layer(s) and conductive layer(s). It should be noted that the spatial relationship (for example, under or on) between the layers mentioned in the present disclosure is to describe the spatial relationship of the layers in the structures shown in the figures. The second conductive layer M2, the conductive layer M3 and the conductive layer M4 may include any suitable conductive material, such as metal materials, but not limited thereto. The insulating layer IL4 may include any suitable insulating material. The material of the insulating layer IL4 and the material of the insulating layer IL3 may be the same or different. In the present embodiment, a conductive layer (such as the second conductive layer M2) of the second circuit structure CL2 may contact the bottom surface S2 of the encapsulation layer EN and extend into the opening OP of the encapsulation layer EN. As shown in FIG. 2, the second conductive layer M2 of the second circuit structure CL2 may extend into the openings OP and extend on the sidewalls SW of the openings OP. Since the openings OP may penetrate the encapsulation layer EN, and the first conductive layer M1 of the first circuit structure CL1 may overlap the openings OP in the normal direction of the electronic device ED, the second conductive layer M2 may contact the first conductive layer M1. In other words, the second circuit structure CL2 and the first circuit structure CL1 may be electrically connected to each other through the openings OP. As mentioned above, since the first circuit structure CL1 may be electrically connected to the electronic elements EL, the electronic elements EL may be electrically connected to the second circuit structure CL2 through the first circuit structure CL1.

The connecting structure CS may be disposed in the opening OP of the encapsulation layer EN, wherein the connecting structure CS may include a first sub layer SL1 and a second sub layer SL2. The first sub layer SL1 may be disposed between the encapsulation layer EN and the second sub layer SL2, and the first sub layer SL1 may cover the sidewall SW of the opening OP. Specifically, the first sub layer SL1 of the connecting structure CS may be the portion of the second conductive layer M2 of the second circuit structure CL2 extending into the opening OP and covering the sidewall SW of the opening OP. In other words, the portion of the second conductive layer M2 may extend into the opening OP and form the first sub layer SL1. Therefore, the first sub layer SL1 of the connecting structure CS may be connected to the second conductive layer M2 of the second circuit structure CL2 or may be in the same layer as the second conductive layer M2. In addition, the first sub layer SL1 and at least a portion of the second conductive layer M2 may include the same material. The second sub layer SL2 may be located at a side of the first sub layer SL1 opposite to the sidewall SW, that is, the first sub layer SL1 may be located between the encapsulation layer EN and the second sub layer SL2. Specifically, the second sub layer SL2 may be formed on the surface of the first sub layer SL1. In such condition, the first sub layer SL1 may for example serve as the seed layer, such that the second sub layer SL2 may be disposed on the surface of the first sub layer SL1. Similarly, the second conductive layer M2 may serve as the seed layer, such that the conductive layer M3 may be disposed on the surface of the second conductive layer M2. The second sub layer SL2 may include any suitable conductive material, such as copper, titanium, alloy of the above-mentioned materials or combinations of the above-mentioned materials, but not limited thereto. It should be noted that in some embodiments, the first conductive layer M1 of the first circuit structure CL1 may serve as the seed layer, such that other conductive layers may be disposed on the surface of the first conductive layer M1. Therefore, as shown in FIG. 1, the electronic elements EL may be electrically connected to the second circuit structure CL2 through the first circuit structure CL1 and the connecting structure CS.

According to the present embodiment, the electronic device ED may further include bonding elements BE, wherein the bonding elements BE may be disposed at the surface of the second circuit structure CL2 opposite to the electronic elements EL (for example, the bottom surface of the insulating layer IL4 shown in FIG. 1, but not limited thereto). The bonding elements BE may be electrically connected to the second circuit structure CL2. For example, the bonding elements BE may be electrically connected to the conductive layer M4 of the second circuit structure CL2, thereby being electrically connected to the conductive layer M3 and the second conductive layer M2 of the second circuit structure CL2. The electronic elements EL may be electrically connected to the bonding elements BE through the first circuit structure CL1, the connecting structure CS and the second circuit structure CL2. The bonding elements BE may be electrically connected to any suitable external electronic unit (not shown). In such condition, the electronic elements EL may be electrically connected to the external electronic unit through the bonding elements BE. The external electronic unit for example includes printed circuit board, but not limited thereto. In other words, the bonding position of the electronic device ED and the external electronic unit may be at the rear side (that is, the side corresponding to the rear surface) of the electronic element EL in the present embodiment. In the present embodiment, the bonding elements BE may include nickel, gold, tin, silver, alloys of the above-mentioned metals, anisotropic conductive film (ACF), solder or other suitable materials. In such condition, the bonding elements BE may further provide protection to the conductive layer(s) of the second circuit structure CL2 (for example, prevent oxidation of the conductive layer(s)) in addition to electrically connecting the electronic elements EL to the external electronic unit, thereby improving the reliability of the electronic device ED. As shown in FIG. 1, in the present embodiment, the bonding elements BE may not overlap the openings OP of the encapsulation layer EN in the normal direction of the electronic device ED. In other words, the bonding elements BE may be disposed misaligned with the openings OP, but not limited thereto.

In the present embodiment, the conductive layers in the first circuit structure CL1 and the second circuit structure CL2 may be patterned, such that the conducting paths of the conductive pads CP of the electronic elements EL may be different, or the conductive pads CP of the electronic elements EL may be electrically connected to different external electronic units. Specifically, the first conductive layer M1 may be patterned and include a plurality of portions which are electrically isolated from each other, and the conductive pads CP may be electrically connected to different portions of the first conductive layer M1. In some embodiments, the conductive pads CP of different electronic elements EL may be electrically connected to different portions of the first conductive layer M1. In some embodiments, the conductive pads CP of an electronic element EL may be electrically connected to different portions of the first conductive layer M1. In addition, the second conductive layer M2 and the conductive layer M3 of the second circuit structure CL2 may be patterned and respectively include a plurality of portions which are electrically isolated from each other, wherein these portions may respectively be electrically connected to different portions of the first conductive layer M1, such that different conductive pads CP may be electrically connected to different portions of the second conductive layer M2 (and the conductive layer M3). Furthermore, the conductive layer M4 may be patterned to correspond to the disposition positions of the bonding elements BE, wherein the bonding elements BE may be electrically connected to different portions of the second conductive layer M2 (and the conductive layer M3) through the conductive layer M4. Therefore, different conductive pads CP may be electrically connected to different bonding elements BE. For example, as shown in FIG. 1, the conductive pad CP1 of the electronic element EL in the left side may be electrically connected to the portion P1 of the first conductive layer M1, and the portion P1 of the first conductive layer M1 may be electrically connected to the portion P2 of the conductive layer M3 through the connecting structure CS, thereby electrically connecting the conductive pad CP1 to the bonding element BE1 and the bonding element BE2, but not limited thereto. Similarly, the conductive pad CP2 and the conductive pad CP3 of the electronic element EL in the left side may be electrically connected to the portion P3 of the first conductive layer M1, and the portion P3 of the first conductive layer M1 may be electrically connected to the portion P4 of the conductive layer M3 through the connecting structure CS, thereby electrically connecting the conductive pad CP2 and the conductive pad CP3 to the bonding element BE3, the bonding element BE4 and the bonding element BE5, but not limited thereto. It should be noted that although it is not shown in FIG. 1, the conductive pads CP of the electronic element EL in the right side may be electrically connected to other bonding elements BE. In some embodiments, the first circuit structure CL1 and the second circuit structure CL2 may respectively include a redistribution layer (RDL), such that the conductive pads CP of the electronic elements EL may be electrically connected to the bonding elements BE at any suitable position through the layout of wires in the redistribution layer. In some embodiments, the first circuit structure CL1 and the second circuit structure CL2 may further include driving elements, such as thin film transistor elements, but not limited thereto. In such condition, the electronic elements EL may be controlled by the first circuit structure CL1 and/or the second circuit structure CL2. It should be noted that the above-mentioned contents just exemplarily describes the embodiment that different conductive pads CP are electrically connected to different bonding elements BE through the pattern designs of the first circuit structure CL1 and the second circuit structure CL2, and the present embodiment is not limited thereto. In other embodiments, the way of electrically connecting the conductive pads CP and the bonding elements BE and the layer designs and the patter designs of the first circuit structure CL1 and the second circuit structure CL2 may be adjusted according to the demands of design of the electronic device ED.

As mentioned above, the electronic device ED of the present disclosure includes the electronic elements EL surrounded (or encapsulated) by the encapsulation layer EN, the first circuit structure CL1 and the second circuit structure CL2 respectively disposed at two sides of the electronic elements EL, and the connecting structures CS disposed in the openings OP of the encapsulation layer EN, wherein the first circuit structure CL1 and the second circuit structure CL2 respectively include the structure formed by stacking conductive layer(s) and insulating layer(s), such that the electronic elements EL may be connected to the bonding elements BE through the first circuit structure CL1, the connecting structure CS and the second circuit structure CL2, thereby being electrically connected to the external electronic unit. The electronic device ED of the present disclosure may include quad flat no leads (QFN) package structure, and compared with the transitional QFN package structure, the lead frame and the wires for bonding the electronic elements to the lead frame are neglected in the electronic device ED. That is, the manufacturing process of the electronic device ED may not include wire bonding. Since the electronic device does not include the lead frame, the production cost of the electronic device ED may be reduced. In addition, since the electronic elements EL of the electronic device ED may not be electrically connected to the external electronic unit through wire bonding, the entire thickness of the electronic device ED may be reduced.

In addition, as shown in FIG. 1, the second circuit structure CL2 may include a conductive layer (that is, the second conductive layer M2) contacting the rear surface (that is, the bottom surface S4) of the electronic element EL. In such condition, the heat dissipation effect of the electronic elements EL may be provided by the conductive layer(s) of the second circuit structure CL2, thereby reducing the possibility that the performance of the electronic elements EL are affected due to overheating. For example, the second conductive layer M2 may completely overlap the rear surfaces of the electronic elements EL in the normal direction of the electronic device ED, but not limited thereto. In some embodiments, the second conductive layer M2 may partially overlap the rear surfaces of the electronic elements EL in the normal direction of the electronic device ED. Specifically, the heat generated by the electronic elements EL may be conducted through the second conductive layer M2 which contacts the rear surface of the electronic elements EL, the conductive layer M3 and the conductive layer M4, thereby achieving the effect of heat dissipation. The second conductive layer M2, the conductive layer M3 and the conductive layer M4 may for example include conductive materials with great thermal conductivity, such as copper, but not limited thereto.

In addition, as shown in FIG. 1, in the present embodiment, the second conductive layer M2 and the conductive layer M3 of the second circuit structure CL2 may be surrounded by the insulating layer IL4, that is, the side surfaces of the second conductive layer M2 and the conductive layer M3 may be covered by the insulating layer IL4. In other words, the second conductive layer M2 and the conductive layer M3 may not be exposed. In such condition, the reliability of the second circuit structure CL2 may be improved by the insulating layer IL4. In some embodiments, the side surfaces of the second conductive layer M2 and the conductive layer M3 may not be covered by the insulating layer IL4. In other words, the side surfaces of the second conductive layer M2 and the conductive layer M3 may be exposed, or the side surfaces of the second conductive layer M2 and the conductive layer M3 may be aligned with the side surface of the encapsulation layer EN. In such condition, the heat dissipation effect of the electronic elements EL provided by the conductive layer(s) of the second circuit structure CL2 may be improved.

Referring to FIG. 2, FIG. 2 schematically illustrates a cross-sectional view of an electronic device according to a variant embodiment of the first embodiment of the present disclosure. According to the present variant embodiment, the bonding elements BE of the electronic device ED may overlap or partially overlap the openings OP of the encapsulation layer EN in the normal direction of the electronic device ED. In such condition, the conductive layers corresponding to the openings OP (for example, the conductive layer M3 and the conductive layer M4) and the bonding elements BE may include concave surface due to being affected by the topography of the openings OP. For example, as shown in FIG. 2, the bonding elements BE (such as the bonding element BE1 and the bonding element BE3) corresponding to the openings OP may respectively have a surface S6, wherein the surface S6 may be a concave surface, but not limited thereto. The surface S6 may be the surface of the bonding element BE in contact with the external electronic unit. In addition, in the present variant embodiment, the sidewalls SW of the openings OP of the encapsulation layer EN may include rough surfaces, but not limited thereto. The feature that the sidewalls SW of the openings OP include rough surfaces described herein may be applied to each of the embodiments and variant embodiments of the present disclosure, and will not be redundantly described in the following. Moreover, in the present variant embodiment, the insulating layer IL3 of the first circuit structure CL1 may expose a portion of the surface (that is, the surface S 1) of the encapsulation layer EN, but not limited thereto. The features of other elements and/or layers of the electronic device ED shown in FIG. 2 may refer to the content mentioned above, and will not be redundantly described. It should be noted that "an element has a rough surface" described above may represent that the surface of the element has ups and downs, or the surface of the element has crests and valleys along the direction Z or a direction perpendicular to the direction Z when a cross-sectional view of the electronic device ED is observed by an electron microscope.

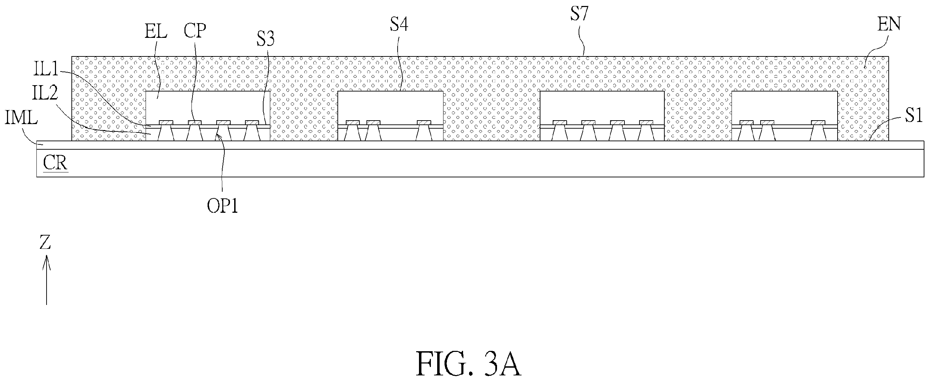

Referring to FIG. 3A to FIG. 3F, FIG. 3A to FIG. 3F schematically illustrate the manufacturing process of the electronic device according to the first embodiment of the present disclosure. According to the present embodiment, the manufacturing method of the electronic device ED may include the following steps:
S102: providing an electronic element;
S104: forming an encapsulation layer surrounding the electronic element, wherein the encapsulation layer has a top surface and a bottom surface;
S106: forming an opening in the encapsulation layer, wherein the opening connects the top surface and the bottom surface;
S 108: disposing a first circuit structure at the top surface of the encapsulation layer;
S 110: disposing a second circuit structure at the bottom surface of the encapsulation layer; and
S 112: forming a connecting structure in the opening, wherein the electronic element is electrically connected to the second circuit structure through the first circuit structure and the connecting structure.

It should be noted that the above-mentioned steps are the steps included in the manufacturing method of the electronic device ED, which do not refer to the order of the steps. In some embodiments, different steps may be performed simultaneously. In some embodiments, the processes in different steps may be performed alternately. In addition, other steps may be inserted between the steps in the manufacturing method of the electronic device ED according to the demands. In addition, any step in the manufacturing method of the electronic device ED may be adjusted in order or deleted according to the demands.

The processes shown in FIG. 3A to FIG. 3F will be taken as an example to describe the manufacturing method of the electronic device ED of the present embodiment. It should be noted that the manufacturing method of the electronic device ED shown in FIG. 3A to FIG. 3F is exemplary, and the present disclosure is not limited thereto.

As shown in FIG. 3A, the manufacturing method of the electronic device ED may include the step S102: providing the electronic elements EL at first. The feature of the electronic elements EL may refer to the contents mentioned above, and will not be redundantly described. After that, the first insulating layers IL1 may be disposed on the top surfaces S3 of the electronic elements EL where the conductive pads CP are located (in FIG. 3A, the top surfaces S3 is located at the lower side of the electronic elements EL), and the second insulating layers IL2 may be disposed at the surface of the first insulating layer IL1. After that, a portion of the first insulating layers IL1 and a portion of the second insulating layers IL2 may be removed to form the openings OP1, wherein the openings OP1 may correspond to the conductive pads CP of the electronic elements EL, that is, the conductive pads CP may be exposed by the openings OP1. The removing step of the insulating layers mentioned above may include the processes such as photolithography, development, etching, laser drilling, mechanical drilling, cleaning or other suitable processes to make sure the insulating layers are removed, thereby preventing the electrical characteristics from being affected. After that, the complex structure including the electronic elements EL, the first insulating layers IL1 and the second insulating layers IL2 may be adhered to a carrier CR through an intermediate layer IML in the way that the second insulating layers IL2 faces downward (that is, chip face down), such that the complex structure is disposed on the carrier CR. In such condition, the second insulating layers IL2 may be located between the electronic elements EL and the carrier CR. After that, the encapsulation layer EN may be formed on the carrier CR, wherein the encapsulation layer EN may cover the electronic elements EL. In other words, the insulating layers (such as the first insulating layer IL1 and/or the second insulating layer IL2) may be disposed on the surfaces (that is, the top surface S3) of the electronic elements EL before the step of forming the encapsulation layer EN surrounding the electronic elements EL. Therefore, the structure shown in FIG. 3A may be formed. In such condition, the surface of encapsulation layer EN in contact with the intermediate layer IML may be the top surface S1 shown in FIG. 1. In addition, the encapsulation layer EN may include a surface S7 opposite to the carrier CR, wherein the surface S7 may be higher than the rear surfaces (that is, the bottom surfaces S4) of the electronic elements EL, but not limited thereto. The carrier CR may include any suitable supporting material, such as glass substrate, silicon substrate, BT carrier, steel plate or combinations of the above-mentioned materials, but not limited thereto. The intermediate layer IML may include any suitable adhesive material for temporarily fixing the electronic elements EL on the carrier CR, and the adhesion of the adhesive material may be lost in the manufacturing process through any physical way or chemical way.

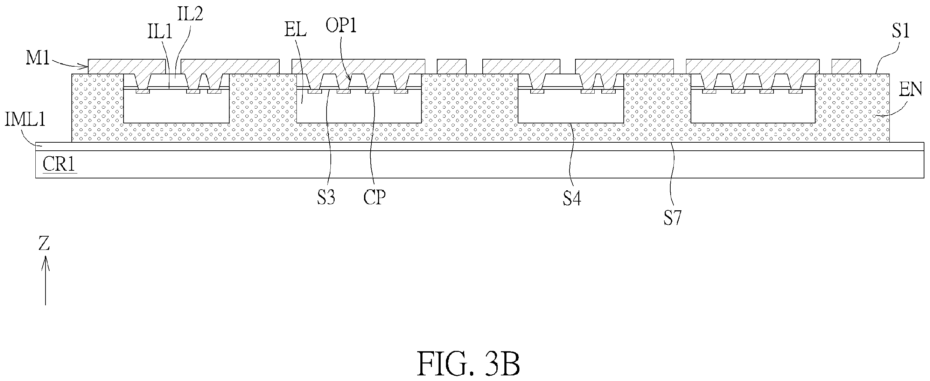

After that, a carrier CR1 may be disposed on the surface S7 of the encapsulation layer EN. Specifically, the encapsulation layer EN may be adhered to the carrier CR1 through the intermediate layer IML1. After that, the formed structure may be flipped, such that the electronic elements EL may be disposed on the carrier CR1, as shown in FIG. 3B. In such condition, the conductive pads CP of the electronic elements EL may face upward, or the active surfaces of the electronic elements EL may face upward. Then, the carrier CR and the intermediate layer IML may be removed to expose the openings OP1 and the encapsulation layer EN, and the first conductive layer M1 may be disposed on the top surface S1 of the encapsulation layer EN. The first conductive layer M1 may be disposed on the top surface S1 of the encapsulation layer EN through any suitable process, such as sputtering, electroplating, chemical plating, but not limited thereto. The first conductive layer M1 may be filled into the openings OP1 and contact the conductive pads CP of the electronic elements EL. In addition, the first conductive layer M1 may be disposed corresponding to the predetermined positions of the openings OP of the encapsulation layer EN formed in the subsequent process, such that the first conductive layer M1 may overlap the openings OP in the normal direction (that is, the direction Z) of the carrier CR1. Specifically, an entire layer of the material of the first conductive layer M1 may be disposed on the top surface S1 of the encapsulation layer EN at first, and then the first conductive layer M1 may be formed through a patterning process. Therefore, the structure shown in FIG. 3B may be formed. According to some embodiments, a cleaning step may be performed before the step of providing the first conductive layer M1 to ensure the cleanliness of the openings OP1, thereby preventing the electrical characteristics from being affected. According to some embodiments, the pattering process mentioned above may include photolithography, dry etching, wet etching, development or other suitable processes, but not limited thereto.

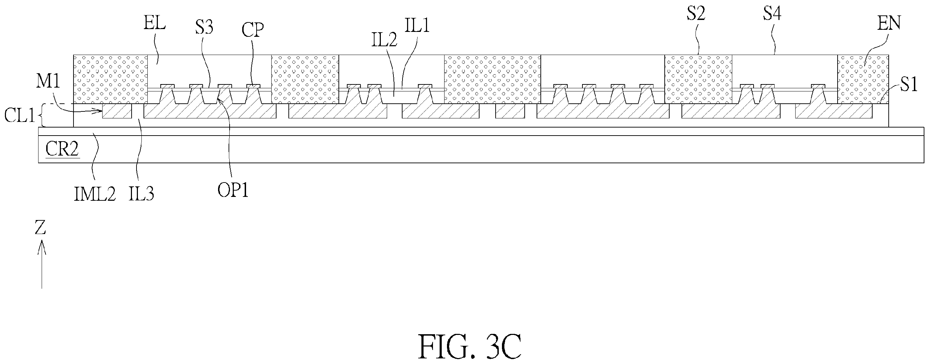

After that, the insulating layer IL3 may be disposed on the first conductive layer M1, thereby completing the step S108 of forming the first circuit structure CL1 at the top surface of the encapsulation layer EN. The step of forming the insulating layer IL3 may include performing a surface treatment on the first conductive layer M1 at first, and then the insulating layer IL3 may be disposed on the first conductive layer M1 through the ways such as coating, adhesion, high temperature and high pressure, and the like. Through the above-mentioned ways, the adhesion between the insulating layer IL3 and the first conductive layer M1 may be increased, but not limited thereto. After the first circuit structure CL1 is formed, a carrier CR2 may be formed on the first circuit structure CL1. Specifically, the first circuit structure CL1 may be adhered to the carrier CR2 through the intermediate layer IML2. After that, the formed structure may be flipped, such that the electronic elements EL may be disposed on the carrier CR2, as shown in FIG. 3C. Then, a polishing process or a grinding process may be performed on the surface S7 of the encapsulation layer EN opposite to the top surface S1 to remove a portion of the encapsulation layer EN to expose the rear surfaces (the bottom surfaces S4) of the electronic elements EL. After the grinding process, the bottom surface S2 of the encapsulation layer EN may be exposed, such that the step S104 of forming the encapsulation layer EN surrounding the electronic elements EL may be completed, wherein the encapsulation layer EN has the top surface S1 and the bottom surface S2. Therefore, the structure shown in FIG. 3C may be formed.

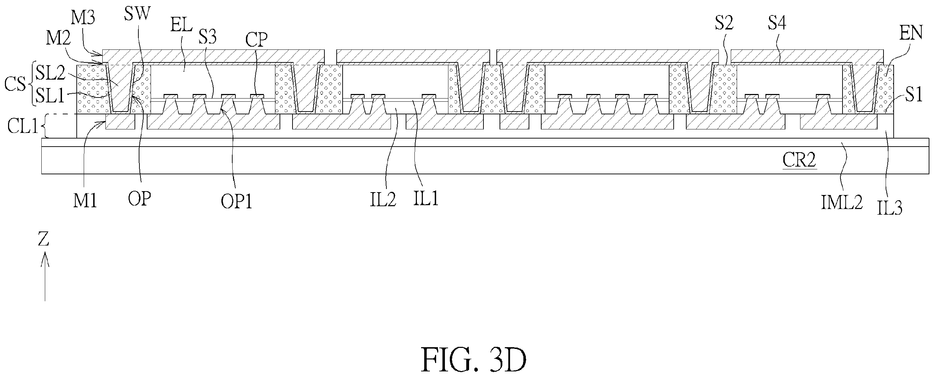

After that, referring to FIG. 3D, the step S106 may be performed to form the openings OP in the encapsulation layer EN, wherein the sidewalls SW of the openings OP connect the top surface S1 and the bottom surface S2 of the encapsulation layer EN. The openings OP penetrating the encapsulation layer EN may be formed by removing a portion of the encapsulation layer EN, wherein the openings OP do not penetrate the electronic elements EL, or the openings OP are not overlapped with the electronic elements EL in the normal direction (that is, the direction Z) of the carrier CR2. As mentioned above, since the first conductive layer M1 may be disposed corresponding to the predetermined positions of the openings OP, after the openings OP are formed, the openings OP may expose the first conductive layer M1. In addition, although it is not shown in FIG. 3D, the surface of the first conductive layer M1 exposed by the openings OP may become concave surface due to being affected by the forming process of the openings OP, but not limited thereto. According to some embodiments, when the first conductive layer M1 has concave surface, the bonding strength between the connecting structure CS and the first conductive layer M1 may be increased, but not limited thereto. Forming the openings OP may include the steps such as laser drilling, mechanical drilling, etching, cleaning, combinations of the above-mentioned steps or other suitable steps. According to some embodiments, the sidewalls SW of the openings OP may include rough surface through the above-mentioned steps of forming the openings OP, thereby increasing the bonding strength between the conductive layer and the encapsulation layer EN, but not limited thereto. After that, the second conductive layer M2 may be formed on the bottom surface S2 of the encapsulation layer EN, wherein the second conductive layer M2 may extend on the bottom surface S2 of the encapsulation layer EN and contact the bottom surface S2. In addition, the second conductive layer M2 may enter the openings OP and extend on the sidewalls SW of the openings OP. Moreover, since the openings OP expose the first conductive layer M1, the second conductive layer M2 may extend on the portion of the first conductive layer M1 exposed by the openings OP, thereby contacting the first conductive layer M1. The second conductive layer M2 may be disposed through any suitable process, such as sputtering, electroplating, chemical plating, but not limited thereto. The portion of the second conductive layer M2 located in the openings OP may be the first sub layers SL1 of the connecting structures CS, that is, the second conductive layer M2 of the second circuit structure CL2 and the first sub layers SL1 of the connecting structures CS may be formed at the same time or be the same layer. After the second circuit structure CL2 and the first sub layers SL1 are formed, the second sub layers SL2 are formed in the openings OP. Specifically, the second sub layers SL2 may be formed on the first sub layers SL1. The second sub layers SL2 may for example be formed by electroplating, but not limited thereto. The first sub layer SL1 may be located between the encapsulation layer EN and the second sub layer SL2, and the first sub layer SL1 may cover the sidewall SW of the opening OP. The first sub layer SL1 may for example serve as the seed layer, such that the second sub layer SL2 may be disposed on the surface of the first sub layer SL1. After the second sub layers SL2 are formed, the step S112 of forming the connecting structures CS in the openings OP may be completed, wherein the electronic elements EL are electrically connected to the second circuit structure CL2 through the first circuit structure CL1 and the connecting structures CS. After that, the conductive layer M3 may be formed on the second conductive layer M2, wherein the conductive layer M3 may contact the second sub layers SL2. The conductive layer M3 may for example be formed by electroplating, but not limited thereto. The second conductive layer M2 may for example serve as the seed layer, such that the conductive layer M3 may be disposed on the second conductive layer M2. In some embodiments, the second sub layers SL2 and the conductive layer M3 may be formed in the same process, for example, the second sub layers SL2 and the conductive layer M3 may be formed at the same time through electroplating. Therefore, the structure shown in FIG. 3D may be formed.

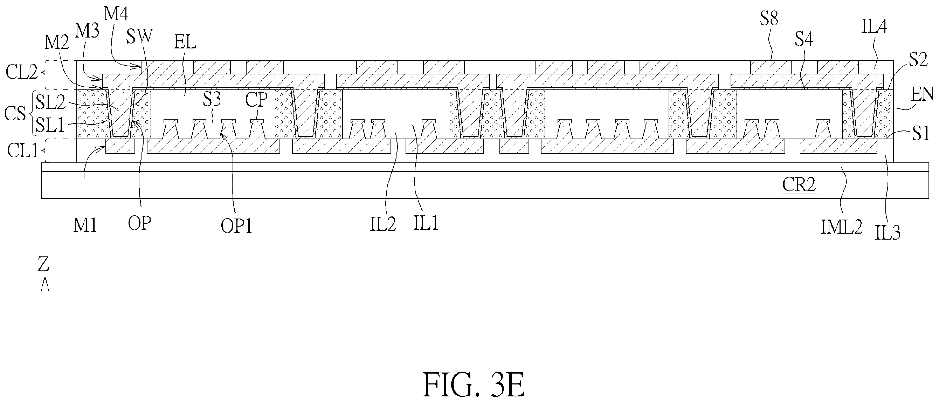

After that, as shown in FIG. 3E, the conductive layer M4 may be disposed on the conductive layer M3, wherein the conductive layer M4 may be patterned. Forming the conductive layer M4 may include the steps such as dry etching, wet etching, electroplating, grinding, laser cleaning or other suitable steps, but not limited thereto. After that, the insulating layer IL4 may be disposed on the conductive layer M4, such that the step S110 of disposing the second circuit structure at the bottom surface of the encapsulation layer may be completed. The insulating layer IL4 may surround the second conductive layer M2, the conductive layer M3 and the conductive layer M4 and expose a surface S8 of the conductive layer M4 opposite to the conductive layer M3. Specifically, after the insulating layer IL4 is disposed, if the insulating layer IL4 covers the surface S8 of the conductive layer M4, a grinding process may be performed on the insulating layer IL4, such that the surface S8 of the conductive layer M4 may be exposed, but not limited thereto. Therefore, the structure shown in FIG. 3E may be formed.

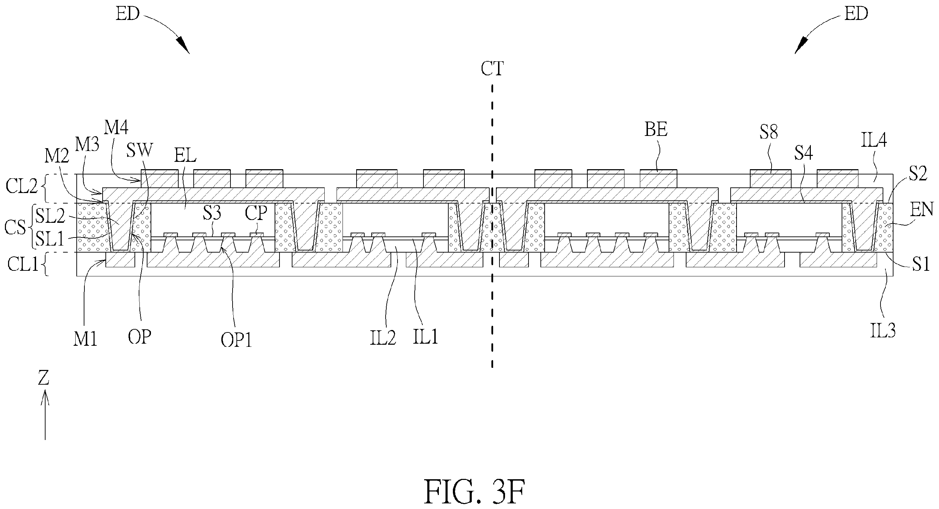

After the second circuit structure CL2 is formed, the carrier CR2 and the intermediate layer IML2 may be removed. After that, the bonding elements BE may be formed on the conductive layer M4, wherein the bonding elements BE may be disposed corresponding to the conductive layer M4. Therefore, the structure shown in FIG. 3F may be formed. After that, a cutting process may be performed on the structure shown in FIG. 3F, thereby forming a plurality of electronic devices ED. For example, the structure shown in FIG. 3F may be cut along a cutting trench CT, thereby forming the electronic device ED shown in FIG. 1.

Other embodiments of the present disclosure will be described in the following. In order to simplify the description, the same elements or layers in the following embodiments would be labeled with the same symbol, and the features thereof will not be redundantly described. The differences between the embodiments will be detailed in the following.

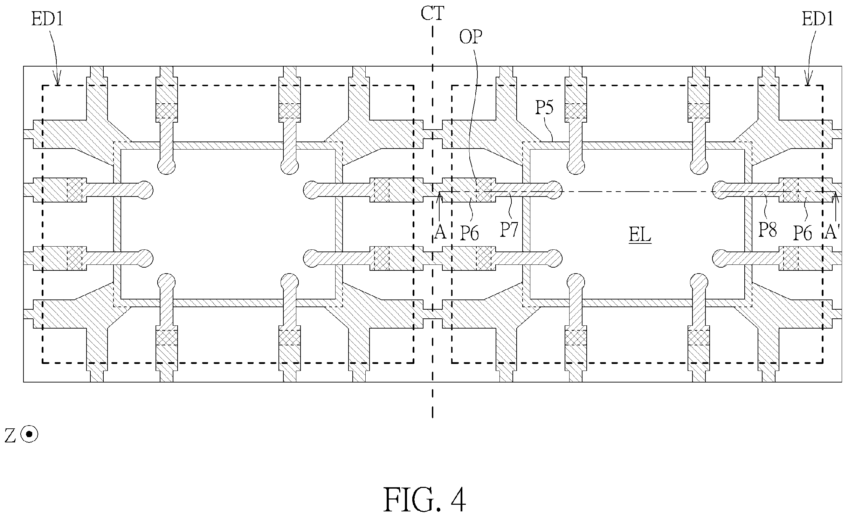

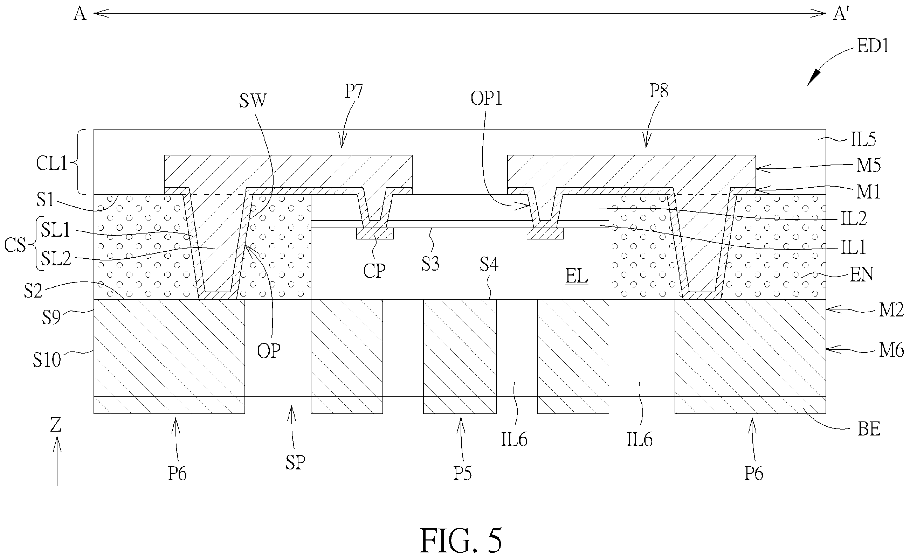

Referring to FIG. 4 and FIG. 5, FIG. 4 schematically illustrates a top view of an electronic device according to a second embodiment of the present disclosure, and FIG. 5 schematically illustrates a cross-sectional view of the electronic device according to the second embodiment of the present disclosure. Specifically, FIG. 4 shows the top view of two electronic devices ED1 formed on the same carrier. After the cutting process (for example, cut along the cutting trench CT, but not limited thereto), the structure shown in FIG. 4 may be divided into two electronic devices ED1 respectively shown in the dotted frames in FIG. 4. In order to simplify the figure, FIG. 4 just shows the conductive layers of the first circuit structure CL1 and the second circuit structure CL2 and the electronic elements EL of the electronic device ED1, and the detailed structure of the electronic device ED1 may refer to FIG. 5, but not limited thereto. In addition, the structure shown in FIG. 5 may be the cross-sectional structure of the structure shown in FIG. 4 along a section line A-A'. As shown in FIG. 5, the electronic device ED1 may include the electronic element EL, the encapsulation layer EN surrounding the electronic element EL, the first circuit structure CL1 disposed on the top surface S1 of the encapsulation layer EN and the second circuit structure CL2 disposed under the bottom surface S2 of the encapsulation layer EN. The features of the electronic element EL and the encapsulation layer EN may refer to the contents mentioned above, and will not be redundantly described.

According to the present embodiment, the first circuit structure CL1 may include the first conductive layer M1, the conductive layer M5 and the insulating layer IL5, but not limited thereto. The first conductive layer M1 may be in contact with the top surface S1 of the encapsulation layer EN. The conductive layer M5 may be formed on the first conductive layer M1. The insulating layer IL5 may cover the first conductive layer M1 and the conductive layer M5. In the present embodiment, the first conductive layer M1 of the first circuit structure CL1 may enter the openings OP and extend on the sidewalls SW of the openings OP. In other words, the first sub layers SL1 of the connecting structures CS in the present embodiment may be connected to the first conductive layer M1 or in the same layer as the first conductive layer M1. The first conductive layer M1 may for example serve as the seed layer, such that the conductive layer M5 may be formed on the first conductive layer M1. The first conductive layer M1 may extend into the openings OP1 and contact the conductive pads CP of the electronic element EL. The conductive layer M5 may be filled into the openings OP1, but not limited thereto. In the present embodiment, the conductive layers (such as the first conductive layer M1 and the conductive layer M5, but not limited thereto) of the first circuit structure CL1 may be patterned to form a plurality of portions, and different conductive pads CP may be electrically connected to different portions of the conductive layers of the first circuit structure CL1, thereby being electrically connected to different portions of the second circuit structure CL2 or different bonding elements BE.

The second circuit structure CL2 may include the second conductive layer M2, the conductive layer M6 and the insulating layer IL6, but not limited thereto. The second conductive layer M2 may contact the bottom surface S2 of the encapsulation layer EN. In addition, the second conductive layer M2 may at least partially overlap the openings OP in the normal direction (that is, the direction Z) of the electronic device ED1, such that the first conductive layer M1 of the first circuit structure CL1 may contact the second conductive layer M2 after entering the openings OP, thereby electrically connecting the first circuit structure CL1 and the second circuit structure CL2. The conductive layer M6 may be located under the second conductive layer M2. In the present embodiment, the conductive layers (such as the second conductive layer M2 and the conductive layer M6, but not limited thereto) of the second circuit structure CL2 may be patterned to form the space SP, and the insulating layer IL6 may be disposed in the space SP. In other words, the second conductive layer M2 and the conductive layer M6 may be patterned at first, and then the insulating layer IL6 may be disposed. The bottom surface of the insulating layer IL6 may be aligned with the bottom surface of the conductive layer M6. In the present embodiment, the patterned conductive layer M6 may correspond to the patterned second conductive layer M2, or the pattern of the conductive layer M6 may be the same as the pattern of the second conductive layer M2, but not limited thereto. Specifically, as shown in FIG. 4 and FIG. 5, the conductive layers of the second circuit structure CL2 may be patterned to form a portion P5 and a plurality of portions P6, wherein the portion P5 and the portions P6 may respectively include a portion of the second conductive layer M2 and a portion of the conductive layer M6. The portion P5 may correspond to the electronic element EL and contact the rear surface (that is, the bottom surface S4) of the electronic element EL, and the portions P6 may be electrically connected to the first circuit structure CL1. In other words, the electronic element EL may be electrically connected to the portions P6 of the second circuit structure CL2 through the first circuit structure CL1. Since the conductive layers of the second circuit structure CL2 may be in contact with the electronic element EL, it can provide the heat dissipation effect of the electronic element EL. The portion P5 and the portions P6 may be electrically isolated from each other, but not limited thereto. "The portion P5 corresponds to the electronic element EL" mentioned above may represent that the second conductive layer M2 and the conductive layer M6 of the portion P5 correspond to the electronic element EL. "The portions P6 are electrically connected to the first circuit structure CL1" mentioned above may represent that the second conductive layer M2 and the conductive layer M6 of the portions P6 are electrically connected to the first circuit structure CL1. For example, as shown in FIG. 4 and FIG. 5, in the electronic element EL of the electronic device ED1, one of the conductive pads CP may be electrically connected to one of the portions P6 of the conductive layers of the second circuit structure CL2 through a portion (such as the portion P7) of the conductive layer(s) of the first circuit structure CL1 and the connecting structures CS in the openings OP, and another one of the conductive pads CP may be electrically connected to another one of the portions P6 of the conductive layers of the second circuit structure CL2 through another portion (such as the portion P8) of the conductive layer(s) of the first circuit structure CL1 and the connecting structures CS in the openings OP, but not limited thereto. The electronic device ED 1 may further include the bonding elements BE located under the conductive layer M6. Specifically, the bonding elements BE may be disposed corresponding to the conductive layer M6. Therefore, the electronic element EL may be electrically connected to the external electronic unit through the bonding elements BE disposed corresponding to the conductive layer M6 in the portions P6. In some embodiments, the bonding element BE may not be disposed under the conductive layer M6 in the portion P5.

In the present embodiment, the side surface S9 of the outermost second conductive layer M2 and the side surface S 10 of the outermost conductive layer M6 may not be covered by the insulating layer IL6, but not limited thereto. In other words, the side surface S9 and the side surface S10 may be exposed, or the side surface S9 and the side surface S10 may be aligned with the side surface of the encapsulation layer EN. In such condition, the second conductive layer M2 and the conductive layer M6 may be exposed, such that the heat dissipation effect of the electronic element EL provided by the conductive layers of the second circuit structure CL2 may be improved.

In addition, in the present embodiment, the size of the portion P5 of the conductive layers of the second circuit structure CL2 may substantially match the size of the electronic element EL. Specifically, the sides of the portion P5 may substantially correspond to the sides of the electronic element EL. For example, in the top view direction of the electronic device ED1, the portion P5 and the electronic element EL may respectively have a rectangular shape, and the four sides of the portion P5 may correspond to the four sides of the electronic element EL, but not limited thereto. In some embodiments, as shown in FIG. 4, the sides of the portion P5 may slightly protrude from the corresponding sides of the electronic element EL. In some embodiments, as shown in FIG. 5, the sides of the portion P5 may be aligned with the corresponding sides of the electronic element EL. In addition, in some embodiments, as shown in FIG. 5, the second conductive layer M2 and the conductive layer M6 in the portion P5 may be patterned. Therefore, the stress on the portion P5 may be reduced. In some embodiments, the second conductive layer M2 and the conductive layer M6 in the portion P5 may not be patterned.

In the present embodiment, the plurality of electronic devices ED1 may be formed on the same carrier, and these electronic devices ED1 may be separated by a cutting process. In some embodiments, as shown in FIG. 4, the conductive layer(s) of the second circuit structures CL2 of the electronic devices ED1 on the same carrier may be connected to each other. In other words, before the cutting process is performed, the conductive layers of the second circuit structures CL2 of the electronic devices ED1 may be electrically connected to each other. After the cutting process is performed, the conductive layers of the second circuit structures CL2 of the electronic devices ED1 may be disconnected, and the conductive layers (for example, the portions P6 mentioned above) of the second circuit structures CL2 at two sides of the positions where the disconnection of the conductive layers occur may be electrically connected to the external electronic unit, which may serve as the bonding points of the electronic device ED1 and the external electronic unit. It should be noted that in some embodiments, the conductive layers of the second circuit structure CL2 may not be disposed corresponding to the cutting trench CT, that is, the conductive layers of the second circuit structures CL2 of the electronic devices ED1 may not be connected to each other . In such condition, the insulating layer IL6 of the second circuit structure CL2 may be disposed corresponding to the cutting trench CT. Therefore, the difficulty of the cutting process may be reduced, thereby improving the yield of the electronic device ED1.

It should be noted that the structures of the first circuit structure CL1 and the second circuit structure CL2 of the present embodiment are not limited to what is shown in FIG. 4 and FIG. 5, and the first circuit structure CL1 and the second circuit structure CL2 may include any suitable structure according to the demands of the design of the electronic device ED1. The features of other elements and/or layers of the electronic device ED1 shown in FIG. 4 and FIG. 5 may refer to the contents mentioned above, and will not be redundantly described.

The manufacturing method of the electronic device ED1 of the present embodiment will be described in the following.

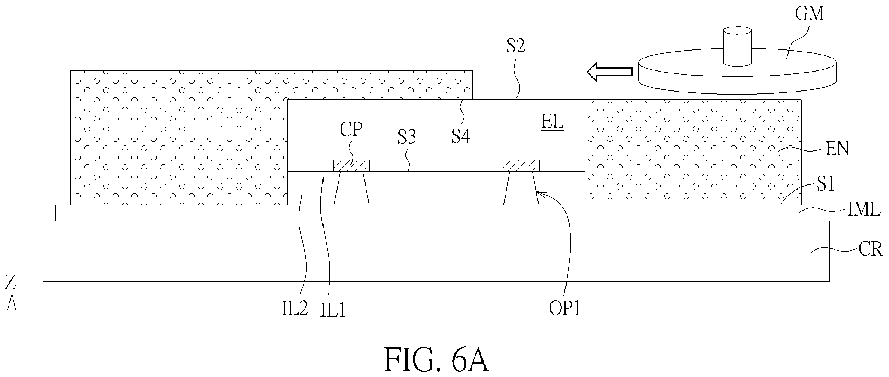

Referring to FIG. 6A to FIG. 6G, FIG. 6A to FIG. 6G schematically illustrate the manufacturing process of the electronic device according to the second embodiment of the present disclosure. As shown in FIG. 6A, the manufacturing method of the electronic device ED1 of the present embodiment may at first include providing the electronic element EL, disposing the first insulating layer IL1 on the top surface S3 of the electronic element EL where the conductive pads CP are located, and disposing the second insulating layer IL2 on the first insulating layer II,1. After that, a portion of the first insulating layer IL1 and a portion of the second insulating layer IL2 may be removed to form the openings OP1, wherein the openings OP1 may expose the conductive pads CP of the electronic element EL. After that, the complex structure including the electronic element EL, the first insulating layer IL1 and the second insulating layer IL2 may be adhered to a carrier CR through an intermediate layer IML in the way that the second insulating layer IL2 faces downward, such that the complex structure is disposed on the carrier. After that, the encapsulation layer EN may be disposed on the carrier CR, wherein the encapsulation layer EN may cover the electronic element EL. In such condition, the top surface S 1 of the encapsulation layer EN shown in FIG. 5 may contact the intermediate layer IML. After that, a grinding process may be performed on the encapsulation layer EN through a grinding tool GM to expose the bottom surface S2 of the encapsulation layer EN. Therefore, the structure shown in FIG. 6A may be formed.

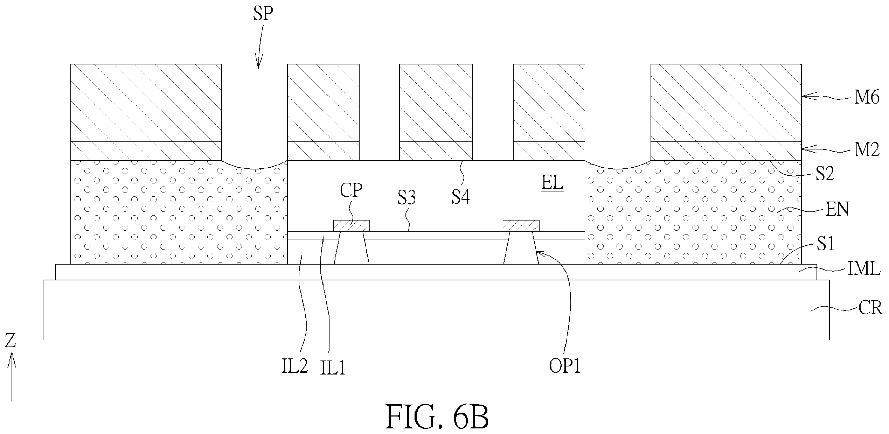

Then, as shown in FIG. 6B, the patterned second conductive layer M2 and the patterned conductive layer M6 may be formed on the bottom surface S2 of the encapsulation layer EN. In the present embodiment, the patterned second conductive layer M2 and the patterned conductive layer M6 may overlap the predetermined disposition positions of the openings OP in the normal direction (that is, the direction Z) of the carrier CR. In an embodiment, the patterned second conductive layer M2 and the patterned conductive layer M6 may be formed through the following method. At first, an entire layer of the second conductive layer M2 may be formed on the bottom surface S2 of the encapsulation layer EN, wherein the second conducive layer M2 may serve as the seed layer. After that, the patterned photo resist layer may be disposed on the second conductive layer M2, and the conductive layer M6 may be disposed between the patterned photo resist layer, thereby forming the patterned conductive layer M6. The pattern of the photo resist layer may be determined according to the pattern of the conductive layer M6. After that, the photo resist layer may be removed, and the second conductive layer M2 may be patterned according to the pattern of the conductive layer M6. Therefore, the structure shown in FIG. 6B may be formed. In such condition, a portion of the second conductive layer M2 and a portion of the conductive layer M6 may be removed to form the space SP, wherein the space SP may expose a portion of the bottom surface S2 of the encapsulation layer EN. It should be noted that the method of forming the patterned second conductive layer M2 and the patterned conductive layer M6 mentioned above is exemplary, and the present embodiment is not limited thereto. According to some embodiments, the steps of forming the space SP may include laser, photolithography, dry etching, wet etching, cleaning or other suitable steps. According to some embodiments, when the space SP is being formed, the recess structure (as shown in FIG. 6B, but not shown in the following figures) may be formed on the surface (that is, the surface S2 of the encapsulation layer EN facing the space SP) of the encapsulation layer EN. Therefore, the bonding ability between the insulating layer IL6 and the encapsulation layer EN may be improved, but not limited thereto.

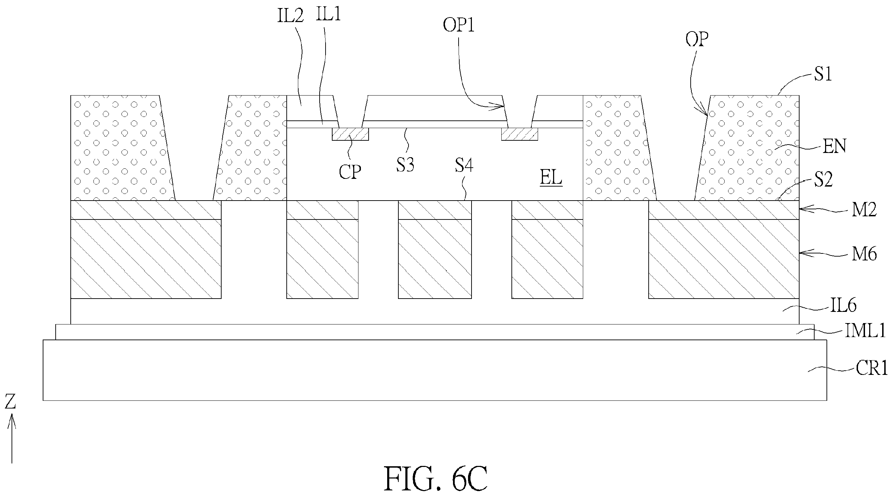

After the patterned second conductive layer M2 and the patterned conductive layer M6 are formed, the insulating layer IL6 may be formed on the conductive layer M6, wherein the insulating layer IL6 may cover the conductive layer M6 and be filled into the space SP. After that, the intermediate layer IML1 and the carrier CR1 may be disposed on the insulating layer IL6 (for example, the insulating layer IL6 may be adhered to the carrier CR1 through the intermediate layer IML1), and the formed structure may be flipped (as shown in FIG. 6C). In such condition, the electronic element EL may be disposed on the carrier CR1. After that, the carrier CR and the intermediate layer IML may be removed. Then, a portion of the encapsulation layer EN may be removed to form the openings OP, wherein the openings OP may expose a portion of the second conductive layer M2. Therefore, the structure shown in FIG. 6C may be formed.

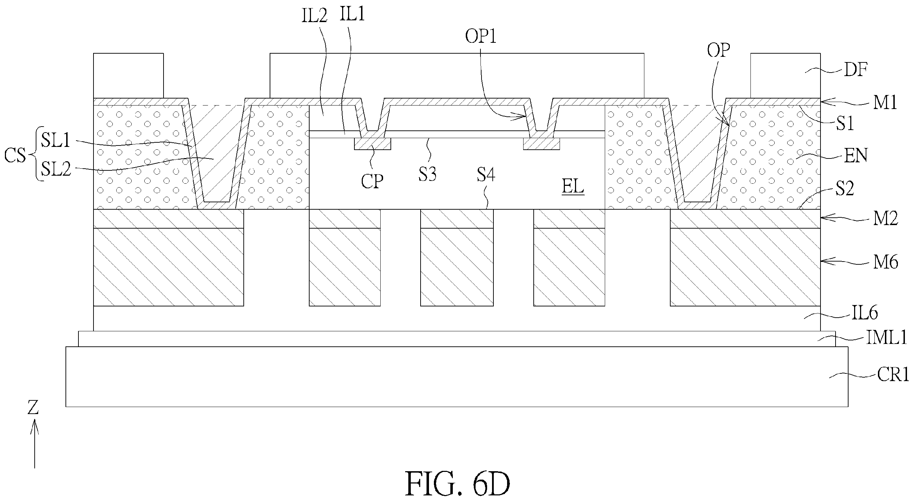

After that, as shown in FIG. 6D, the first conductive layer M1 may be formed on the top surface S1 of the encapsulation layer EN, wherein the first conductive layer M1 may extend on the top surface S1 of the encapsulation layer EN and extend into the openings OP and the openings OP1. The first conductive layer M1 may extend on the sidewalls SW of the openings OP and contact the second conductive layer M2, thereby being electrically connected to the second conductive layer M2. The first conductive layer M1 may extend into the openings OP1 and contact the conductive pads CP of the electronic element EL, thereby being electrically connected to the electronic element EL. The portion of the first conductive layer M1 extending on the sidewalls SW of the openings OP may form the first sub layers SL1 of the connecting structures CS. After that, the second sub layers SL2 of the connecting structures CS in the openings OP may be formed. Specifically, the patterned photo resist DF may be disposed on the first conductive layer M1 at first, wherein the patterned photo resist DF may expose the openings OP. After that, the second sub layers SL2 may be formed in the openings OP through the patterned photo resist DF. The second sub layer SL2 may for example be formed through electroplating, but not limited thereto.

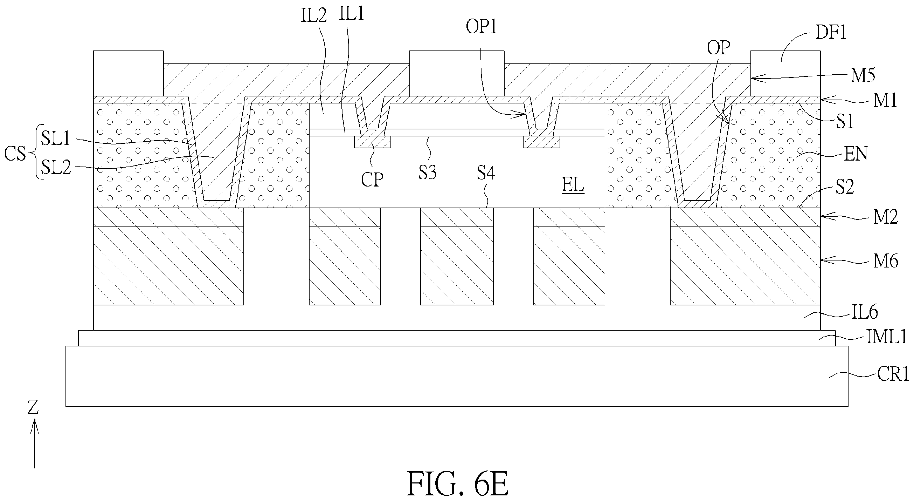

As shown in FIG. 6E, after the second sub layers SL2 are formed, the patterned photo resist DF may be removed, and the patterned photo resist DF1 may be disposed on the first conductive layer M1. The patterned photo resist DF1 may expose the openings OP and the openings OP1. In some embodiments, the patterned photo resist DF1 may be formed by removing a portion (the portion corresponding to the openings OP1) of the patterned photo resist DF. After that, the conductive layer M5 may be formed through the patterned photo resist DF1, wherein the conductive layer M5 may be connected between the openings OP and the openings OP1. The conductive layer M5 may be filled into the openings OP1, but not limited thereto. The conductive layer M5 may for example be formed through electroplating, but not limited thereto.

In the present embodiment, the second sub layers SL2 and the conductive layer M5 may be formed through two electroplating processes, but not limited thereto. In such condition, the second sub layers SL2 in the openings OP may be formed at first, and then the conductive layer M5 filled into the openings OP1 may be formed. Therefore, the possibility of increasing the difficulty of electroplating due to the great depth difference between the opening OP1 and the opening OP may be reduced. In some embodiments, the second sub layers SL2 and the conductive layer M5 may be formed in the same electroplating process.

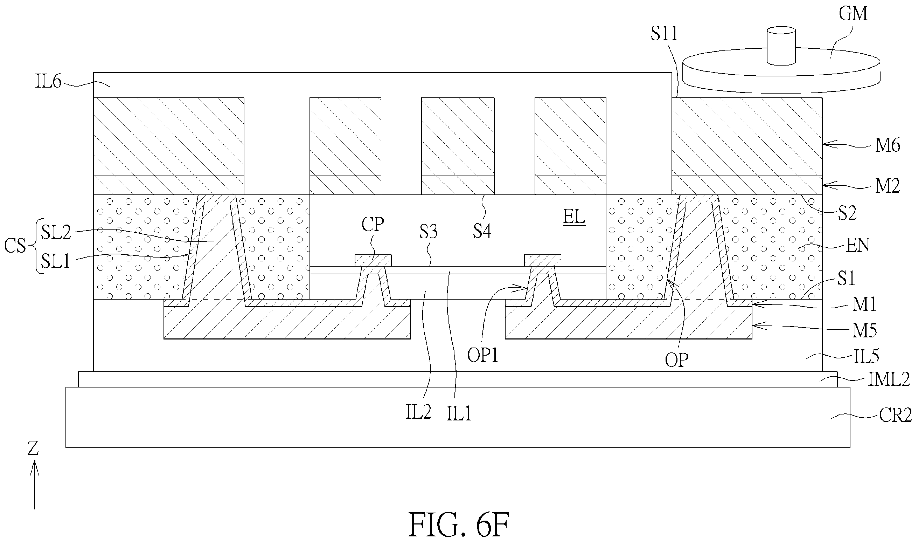

After the conductive layer M5 is formed, a patterning process may be performed on the first conductive layer M1, and the insulating layer IL5 is disposed on the conductive layer M5. The first conductive layer M1 may for example be patterned according to the pattern of the conductive layer M5, such that the first conductive layer M1 may correspond to the conductive layer M5, but not limited thereto. The insulating layer IL5 may cover the conductive layer M5. After that, the intermediate layer IML2 and the carrier CR2 may be disposed on the insulating layer IL5 (for example, the insulating layer IL5 may be adhered to the carrier CR2 through the intermediate layer IML2), and the formed structure may be flipped (as shown in FIG. 6F). In such condition, the electronic element EL may be disposed on the carrier CR2. After that, the carrier CR1 and the intermediate layer IML1 may be removed. Then, a grinding process may be performed on the insulating layer IL6 (for example, a portion of the insulating layer IL6 may be removed through the grinding tool GM), such that the surface (for example, the surface S11) of the conductive layer M6 is exposed. In such condition, the surface of the insulating layer IL6 may be aligned with the surface of the conductive layer M6. Therefore, the structure shown in FIG. 6F may be formed.

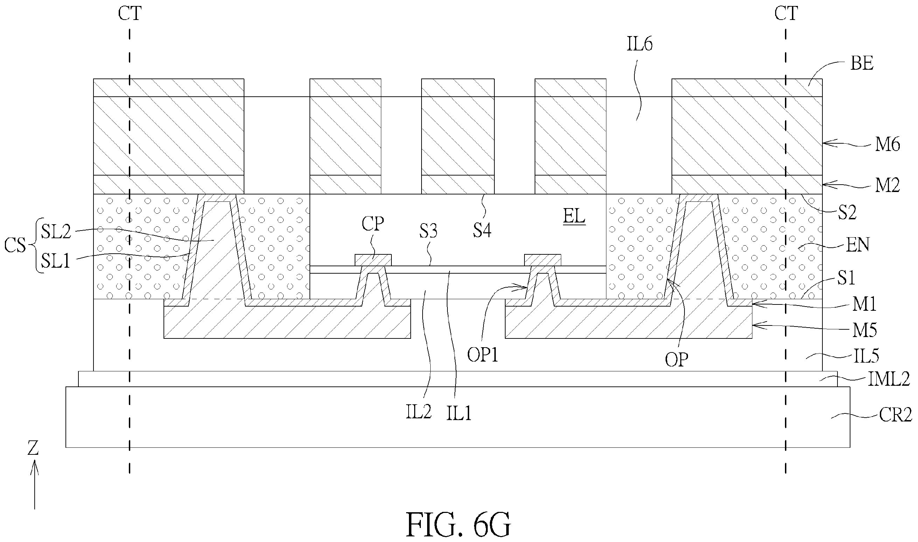

After that, as shown in FIG. 6G, the bonding elements BE may be disposed on the conductive layer M6, wherein the bonding elements BE may correspond to the conductive layer M6. Then, a cutting process may be performed, and the intermediate layer IML2 and the carrier CR2 may be removed, thereby forming the electronic device ED1 shown in FIG. 5. In some embodiments, the intermediate layer IML2 and the carrier CR2 may be removed at first, and the cutting process may be performed. In some embodiments, the cutting process may be performed at first, and the intermediate layer IML2 and the carrier CR2 may be removed.

Another embodiment about the manufacturing method of the electronic device ED 1 will be described in the following.

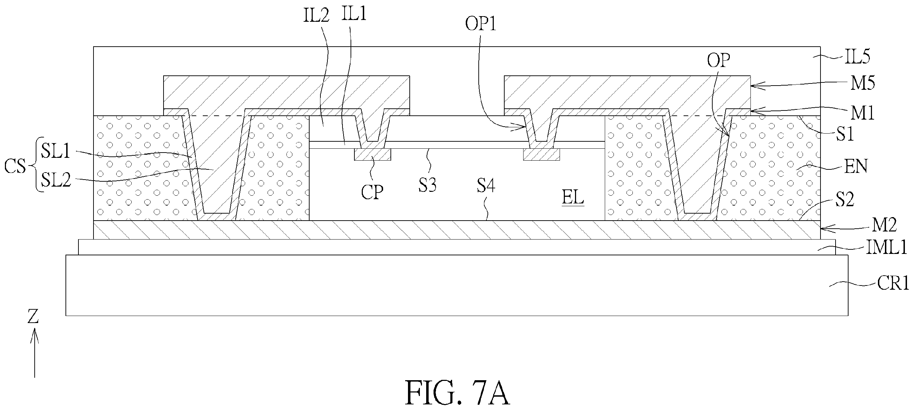

Referring to FIG. 7A to FIG. 7B, FIG. 7A to FIG. 7B schematically illustrate the manufacturing process of the electronic device according to a variant embodiment of the second embodiment of the present disclosure. The manufacturing method of the electronic device ED1 of the present variant embodiment may include providing the structure shown in FIG. 6A at first, wherein an entire layer of the second conductive layer M2 may be disposed on the bottom surface S2 of the encapsulation layer EN after the grinding process is performed on the encapsulation layer EN to expose the bottom surface S2 of the encapsulation layer EN. Then, as shown in FIG. 7A, the intermediate layer IML1 and the carrier CR1 may be disposed on the second conductive layer M2 (for example, the second conductive layer M2 may be adhered to the carrier CR1 through the intermediate layer IML1), and the formed structure may be flipped. In such condition, the electronic element EL may be disposed on the carrier CR1. After that, the carrier CR and the intermediate layer IML shown in FIG. 6A may be removed, and the openings OP may be formed in the encapsulation layer EN.

Then, as shown in FIG. 7A, the first conductive layer M1 may be formed on the top surface S1 of the encapsulation layer EN, wherein the first conductive layer M1 may extend on the top surface S1 and extend into the openings OP and the openings OP1, thereby being electrically connected to the second conductive layer M2 and the electronic element EL. The portion of the first conductive layer M1 extending on the sidewalls SW of the openings OP may form the first sub layers SL1 of the connecting structures CS.

Then, as shown in FIG. 7A, the second sub layers SL2 of the connecting structures CS may be formed in the openings OP, the conductive layer M5 may be formed on the first conductive layer M1, the first conductive layer M1 may be patterned, and the insulating layer IL5 may be disposed on the conductive layer M5. The forming methods of the second sub layers SL2, the conductive layer M5 and the insulating layer IL5 may refer to FIG. 6D to FIG. 6F and related contents mentioned above, and will not be redundantly described.

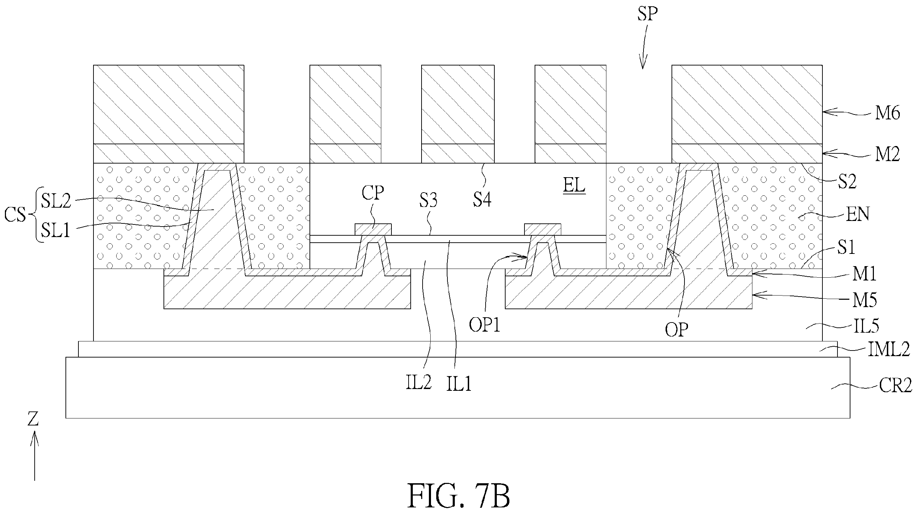

After the insulating layer IL5 is formed, as shown in FIG. 7B, the intermediate layer IML2 and the carrier CR2 may be disposed on the insulating layer IL5 (for example, the insulating layer IL5 may be adhered to the carrier CR2 through the intermediate layer IML2), and the formed structure may be flipped. In such condition, the electronic element EL may be disposed on the carrier CR2. After that, the carrier CR1 and the intermediate layer IML1 may be removed. Then, the step of disposing the conductive layer M6 on the second conductive layer M2 and the step of patterning the second conductive M2 and the conductive layer M6 may be performed, and the details thereof may refer to FIG. 6B and related contents mentioned above, which will not be redundantly described. After the patterned second conductive layer M2 and the patterned conductive layer M6 are formed, the insulating layer IL6 is disposed on the conductive layer M6 (refer to FIG. 6C), a grinding process is performed on the insulating layer IL6 to expose the conductive layer M6 (refer to FIG. 6F), and the bonding elements BE are disposed on the conductive layer M6 (refer to FIG. 6G). After that, a cutting process may be performed to remove the intermediate layer IML2 and the carrier CR2, thereby forming the electronic device ED1 shown in FIG. 5.

It should be noted that the manufacturing method of the electronic device ED1 mentioned above is exemplary, and the present disclosure is not limited thereto.

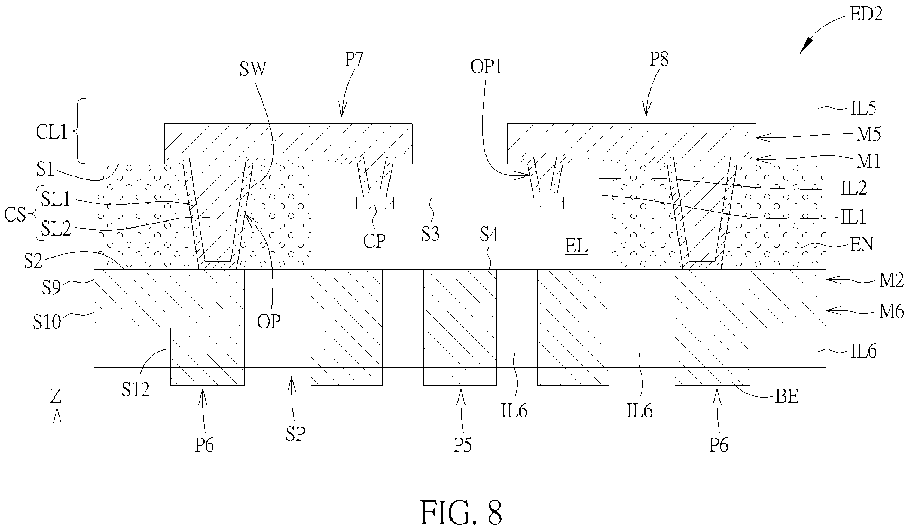

Referring to FIG. 8, FIG. 8 schematically illustrates a cross-sectional view of an electronic device according to a third embodiment of the present disclosure. One of the main differences between the electronic device ED2 of the present embodiment and the electronic device ED1 shown in FIG. 5 is the design of the second circuit structure CL2. According to the present embodiment, the side surface of the outermost portion of the conductive layer of the second circuit structure CL2 may be at least partially covered by the insulating layer and not aligned with the side surface of the encapsulation layer EN. In other words, at least a portion of the outermost portion of the conductive layer of the second circuit structure CL2 may not be exposed. For example, as shown in FIG. 8, the outermost portion of the conductive layer M6 of the second circuit structure CL2 may have a side surface S12 covered by the insulating layer IL6, such that the side surface S12 may not be exposed or not aligned with the side surface of the encapsulation layer EN, but not limited thereto. That is, at least a portion of the outermost portion of the conductive layer M6 may not be exposed. In other words, the insulating layer IL6 may surround a portion of the conductive layer M6. In some embodiments, the insulating layer IL6 may completely cover the side surface of the outermost portion of the conductive layer M6. In some embodiments, the insulating layer IL6 may completely cover the side surface of the outermost portion of the conductive layer M6 and partially cover the side surface of the outermost portion of the first conductive layer M1.

The manufacturing method of the electronic device ED2 of the present embodiment will be described in the following. It should be noted that the manufacturing method of the electronic device ED2 mentioned in the following is exemplary, and the present disclosure is not limited thereto.

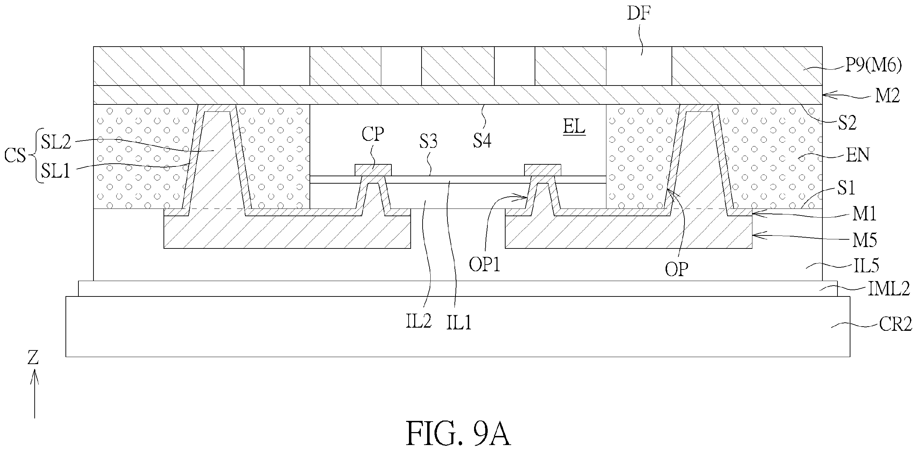

Referring to FIG. 9A to FIG. 9C, FIG. 9A to FIG. 9C schematically illustrate the manufacturing process of an electronic device according to a third embodiment of the present disclosure. According to the present embodiment, the manufacturing method of the electronic device ED2 may include forming the structure shown in FIG. 7A at first. Specifically, the structure shown in FIG. 7A may be formed by the manufacturing process shown in FIG. 7A, but not limited thereto. After that, as shown in FIG.9A, the intermediate layer IML2 and the carrier CR2 may be disposed on the insulating layer IL5, the formed structure may be flipped, and then the intermediate layer IML1 and the carrier CR1 (shown in FIG. 7A) are removed to expose the second conductive layer M2. In such condition, the electronic element EL may be disposed on the carrier CR2. After that, the patterned photo resist DF may be disposed on the second conductive layer M2, and a portion of the conductive layer M6 may be formed through the patterned photo resist DF, that is, the portion P9. The pattern of the patterned photo resist DF may be determined according to the pattern of the portion P9.

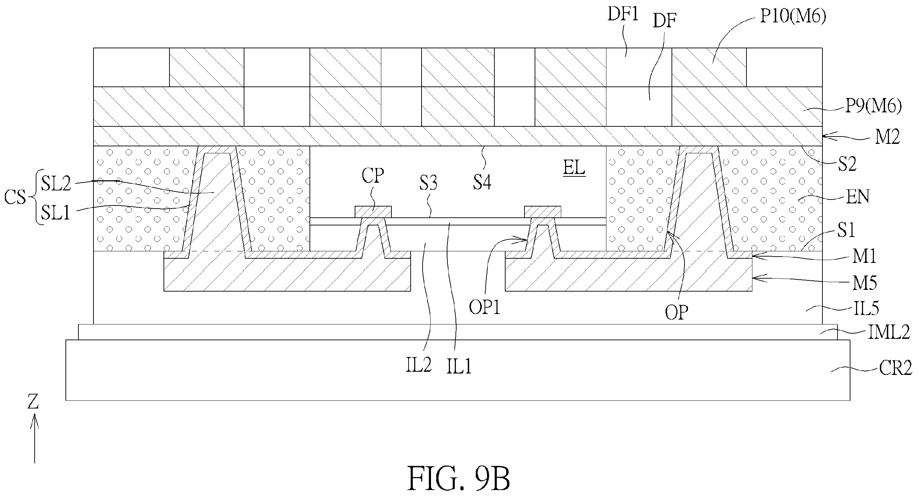

After that, as shown in FIG. 9B, after the portion P9 of the conductive layer M6 is formed, another patterned photo resist DF1 may be disposed on the portion P9. The patterned photo resist DF1 may include a portion corresponding to the patterned photo resist DF and another portion aligned with the side surface of the encapsulation layer EN, but not limited thereto. After the patterned photo resist DF1 is disposed, another portion of the conductive layer M6 may be formed through the patterned photo resist DF1, that is, the portion P10. Since the patterned photo resist DF1 includes the portion aligned with the side surface of the encapsulation layer EN, the portion P 10 may not be aligned with the side surface of the encapsulation layer EN. The portion P9 and the portion P10 of the conductive layer M6 may for example be formed through electroplating, but not limited thereto. In other words, the portion P9 and the portion P10 may be formed through two electroplating processes respectively, thereby forming the conductive layer M6.

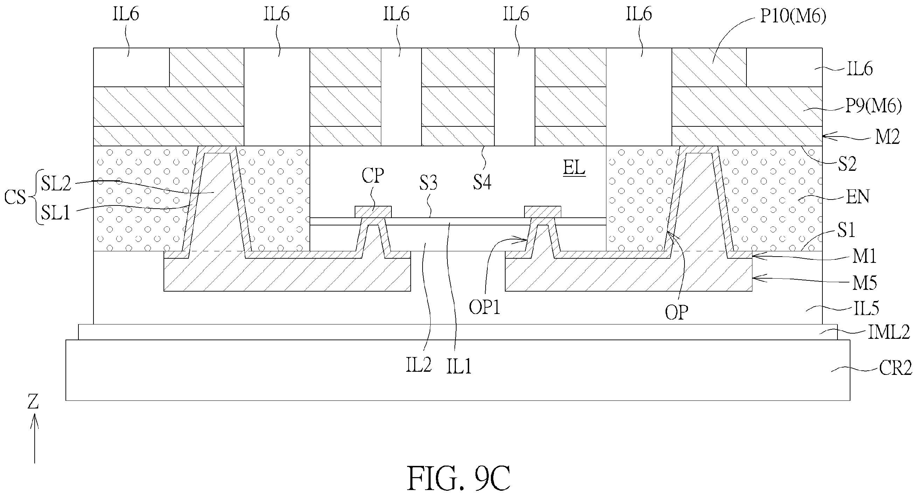

After that, as shown in FIG. 9C, after the conductive layer M6 is formed, the patterned photo resist DF and the patterned photo resist DF 1 may be removed, and a patterning process may be performed on the second conductive layer M2. Specifically, the portion of the second conductive layer M2 exposed after the patterned photo resist DF and the patterned photo resist DF1 are removed may be removed. Then, the insulating layer IL6 may be disposed, wherein the insulating layer IL6 may be filled into the space (not labeled) formed by removing the patterned photo resist DF, the patterned photo resist DF 1 and a portion of the second conductive layer M2. The surface of the insulating layer IL6 may be aligned with the surface of the portion P 10 of the conductive layer M6, or in other words, the insulating layer IL6 does not protrude from the portion P 10 of the conductive layer M6.

After that, the bonding elements BE may be disposed corresponding to the portion P10 of the conductive layer M6, a cutting process may be performed, and the intermediate layer IML2 and the carrier CR2 may be removed, thereby forming the electronic device ED2 shown in FIG. 8.

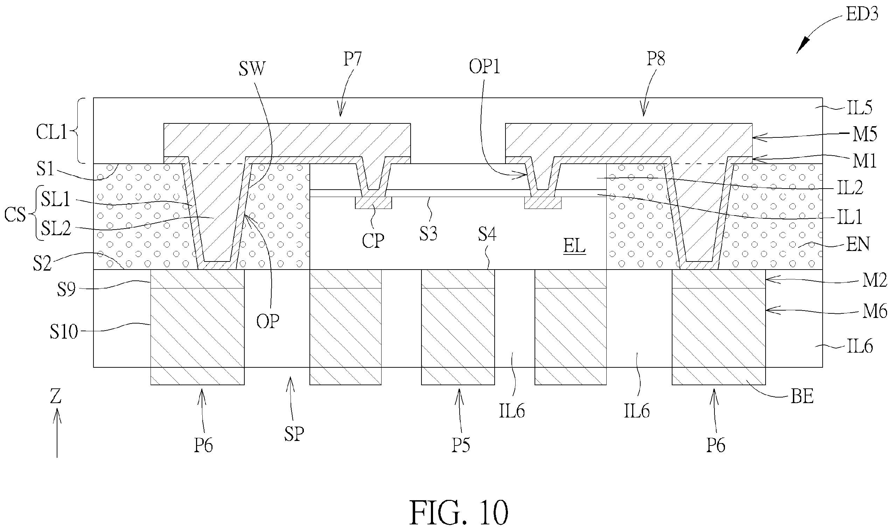

Referring to FIG. 10, FIG. 10 schematically illustrates a cross-sectional view of an electronic device according to a fourth embodiment of the present disclosure. One of the main differences between the electronic device ED3 of the present embodiment and the electronic device ED1 shown in FIG. 5 is the design of the second circuit structure CL2. According to the present embodiment, the side surface(s) of the outermost portion of the conductive layer(s) of the second circuit structure CL2 may be covered by the insulating layer and not aligned with the side surface of the encapsulation layer EN. In other words, the outermost portion of the conductive layer(s) of the second circuit structure CL2 may not be exposed. For example, as shown in FIG. 10, the side surfaces (including the side surface S9 and the side surface S 10 mentioned above) of the outermost portion of the conductive layers (for example, including the second conductive layer M2 and the conductive layer M6) of the second circuit structure CL2 may be covered by the insulating layer IL6, such that the side surfaces of the outermost portion of the conductive layers may not be exposed or not aligned with the side surface of the encapsulation layer EN. In other words, the insulating layer IL6 may surround the conductive layers of the second circuit structure CL2. The reliability of the second circuit structure CL2 may be improved through the above-mentioned design.

The manufacturing method of the electronic device ED3 of the present embodiment will be described in the following. It should be noted that the manufacturing method of the electronic device ED3 mentioned in the following is exemplary, and the present disclosure is not limited thereto.

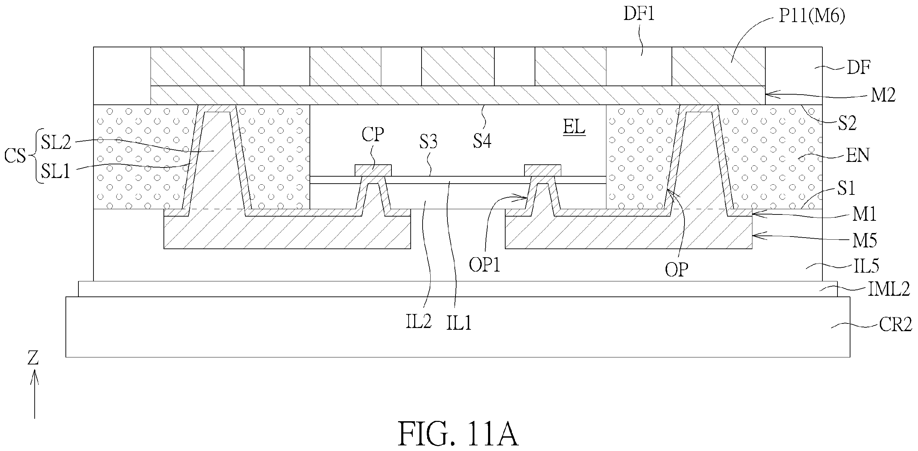

Referring to FIG. 11A to FIG. 11C, FIG. 11A to FIG. 11C schematically illustrate the manufacturing process of an electronic device according to a fourth embodiment of the present disclosure. According to the present embodiment, the manufacturing method of the electronic device ED3 may include forming the structure shown in FIG. 7A at first. Specifically, the structure shown in FIG. 7A may be formed by the manufacturing process shown in FIG. 7A, but not limited thereto. After that, as shown in FIG. 11A, the intermediate layer IML2 and the carrier CR2 are disposed on the insulating layer IL5, the formed structure is flipped, and then the intermediate layer IML1 and the carrier CR1 (shown in FIG. 7A) are removed to expose the second conductive layer M2. In such condition, the electronic element EL may be disposed on the carrier CR2. After that, the second conductive layer M2 may be patterned, and the patterned photo resist DF may be disposed. Specifically, the portion of the second conductive layer M2 adjacent to the outer edge of the encapsulation layer EN may be removed, and the patterned photo resist DF may be disposed corresponding to the position of the removed portion of the second conductive layer M2. The patterned photo resist DF may be aligned with the side surface of the encapsulation layer EN. After the patterned photo resist DF is disposed, the patterned photo resist DF1 may be disposed on the second conductive layer M2, and a portion of the conductive layer M6 may be formed through the patterned photo resist DF and the patterned photo resist DF 1, that is, the portion P11.

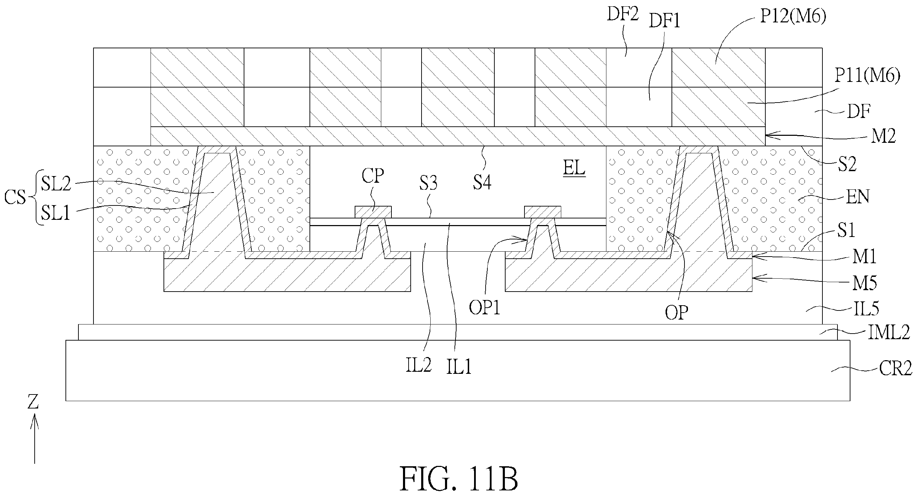

After that, as shown in FIG. 11B, after the portion P11 is formed, the patterned photo resist DF2 may be disposed on the patterned photo resist DF and the patterned photo resist DF1. The patterned photo resist DF2 may correspond to the patterned photo resist DF and the patterned photo resist DF1. After that, another portion of the conductive layer M6 may be formed through the patterned photo resist DF2, that is, the portion P12. Therefore, the conductive layer M6 not aligned with the side surface of the encapsulation layer EN may be formed.

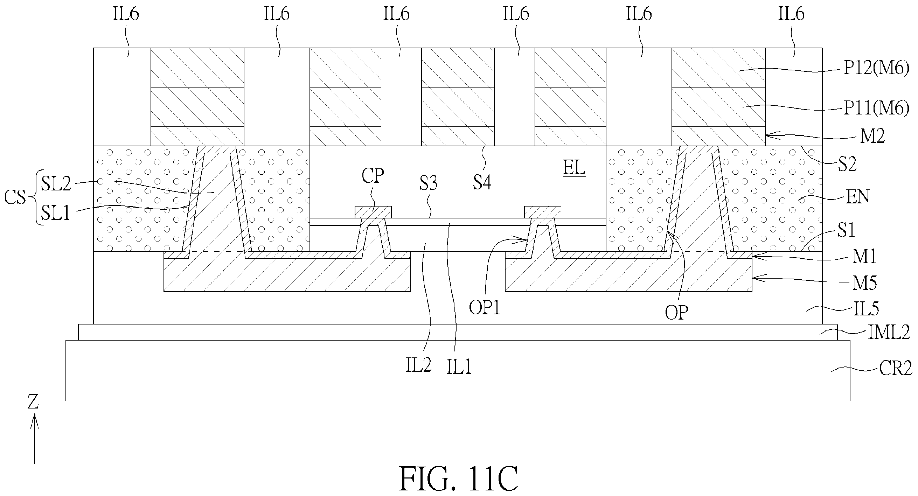

Then, as shown in FIG. 11C, after the conductive layer M6 is formed, the patterned photo resist DF, the patterned photo resist DF1 and the patterned photo resist DF2 may be removed, and a patterning process may be performed on the second conductive layer M2. Specifically, the portion of the second conductive layer M2 exposed after the patterned photo resist DF1 and the patterned photo resist DF2 are removed may be removed. After that, the insulating layer IL6 may be disposed, wherein the insulating layer IL6 may be filled into the space (not labeled) formed by removing the patterned photo resist DF, the patterned photo resist DF1, the patterned photo resist DF2 and a portion of the second conductive layer M2. The surface of the insulating layer IL6 may be aligned with the surface of the portion P12 of the conductive layer M6.

After that, the bonding elements BE may be disposed corresponding to the portion P12 of the conductive layer M6, a cutting process may be performed, and the intermediate layer IML2 and the carrier CR2 may be removed, thereby forming the electronic device ED3 shown in FIG. 10.

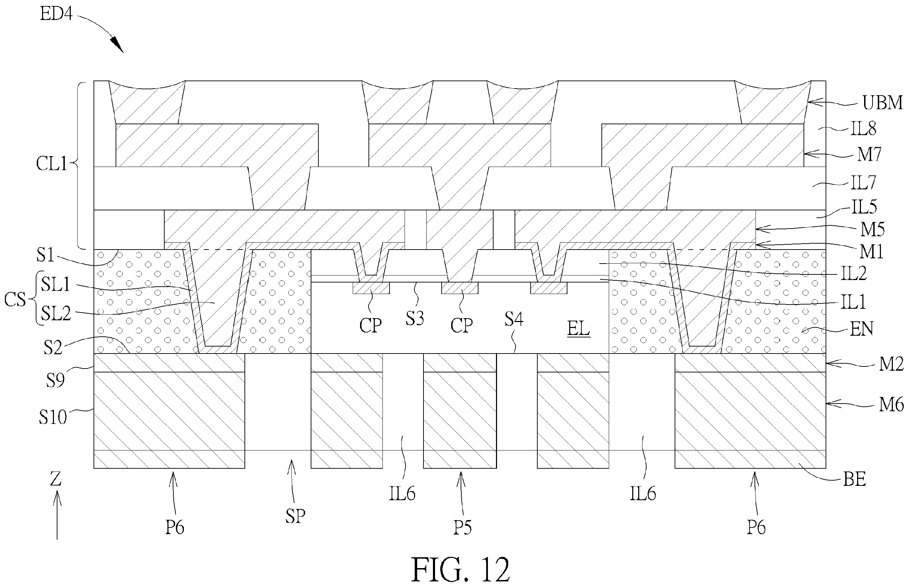

Referring to FIG. 12, FIG. 12 schematically illustrates a cross-sectional view of an electronic device according to a fifth embodiment of the present disclosure. One of the main differences between the electronic device ED4 of the present embodiment and the electronic device ED1 shown in FIG. 5 is the design of the first circuit structure CL1. According to the present embodiment, two sides of the electronic device ED4 may be used to be electrically connected to the external electronic unit. Specifically, the first circuit structure CL1 and the second circuit structure CL2 of the electronic device ED4 may both be electrically connected to the external electronic unit. For example, as shown in FIG. 12, the first circuit structure CL1 may further include the insulating layer IL7 disposed on the insulating layer IL5 and covering the conductive layer M5, the conductive layer M7 disposed on the insulating layer IL7, the insulating layer IL8 disposed on the insulating layer IL7 and covering the conductive layer M7 and the under bump metallization layer UBM disposed at the surface of the insulating layer IL8 in addition to the first conductive layer M1, the conductive layer M5 and the insulating layer IL5, but not limited thereto. The conductive layer M7 may be electrically connected to the conductive layer M5 through the vias penetrating the insulating layer IL7. The under bump metallization layer UBM may contact the conductive layer M7, thereby being electrically connected to the conductive layer M7. In the present embodiment, the under bump metallization layer UBM may be electrically connected to the external electronic unit. The surface of the under bump metallization layer UBM in contact with the external electronic unit may be a concave surface, but not limited thereto. Therefore, the electronic element EL may be electrically connected to the external electronic unit through the under bump metallization layer UBM of the first circuit structure CL1. It should be noted that the first circuit structure CL1 shown in FIG. 12 is exemplary, and the present embodiment is not limited thereto. In some embodiments, a conductive pad CP of the electronic element EL may be electrically connected to the external electronic unit through the first circuit structure CL1. In some embodiments, a conductive pad CP of the electronic element EL may be electrically connected to an external electronic unit through the first circuit structure CL1, and the conductive pad CP may further be electrically connected to another external electronic unit through the second circuit structure CL2.

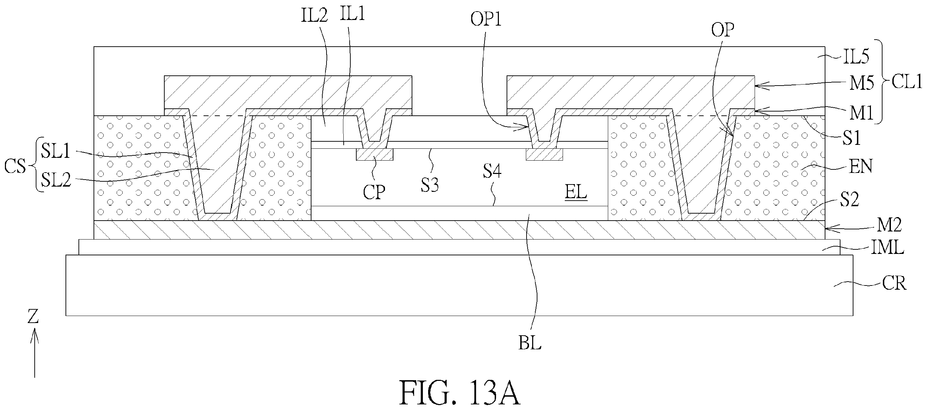

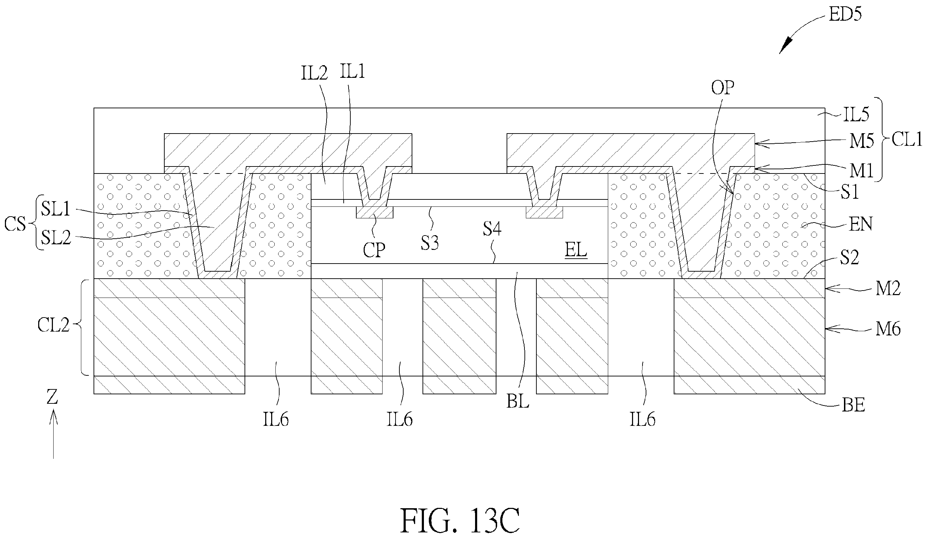

Referring to FIG. 13A to FIG. 13C, FIG. 13A to FIG. 13C schematically illustrate the manufacturing process of an electronic device according to a sixth embodiment of the present disclosure. The structure shown in FIG. 13C is an embodiment of the electronic device ED5 of the present embodiment, but the present embodiment is not limited thereto. As shown in FIG. 13A, the manufacturing method of the electronic device ED5 may include adhering the second conductive layer M2 to the carrier CR through the intermediate layer IML at first. After that, the electronic element EL may be disposed on the second conductive layer M2. In the present embodiment, the electronic element EL may be adhered to the second conductive layer M2 through the bonding layer BL. The bonding layer BL may include any suitable adhesive material. Therefore, the bonding layer BL may be disposed between the electronic element EL and the second conductive layer M2. The electronic element EL may be adhered to the second conductive layer M2 in the way that the conductive pads CP face upward. Then, the first insulating layer IL1 and the second insulating layer IL2 may be disposed on the electronic element EL. After the second insulating layer IL2 is formed, the encapsulation layer EN surrounding the electronic element EL, the first insulating layer IL1 and the second insulating layer IL2 may be formed. The bottom surface S2 of the encapsulation layer EN may contact the second conductive layer M2, and the top surface S1 of the encapsulation layer EN may be aligned with the surface of the second insulating layer IL2 opposite to the first insulating layer IL1. For example, the encapsulation layer EN may be disposed on carrier CR at first, wherein the encapsulation layer EN may cover the electronic element EL, the first insulating layer IL1 and the second insulating layer IL2. After that, a grinding process may be performed on the encapsulation layer EN through the grinding tool GM, such that the surface of the second insulating layer IL2 is exposed.

After the encapsulation layer EN is formed, the openings OP in the encapsulation layer EN, the openings OP1 exposing the conductive pads CP, the connecting structures CS and the first circuit structure CL1 may be formed according to the processes shown in FIG. 7A, thereby forming the structure shown in FIG. 13A. The details of the manufacturing processes of the above-mentioned elements and/or layers may refer to FIG. 7A and related contents mentioned above, and will not be redundantly described.

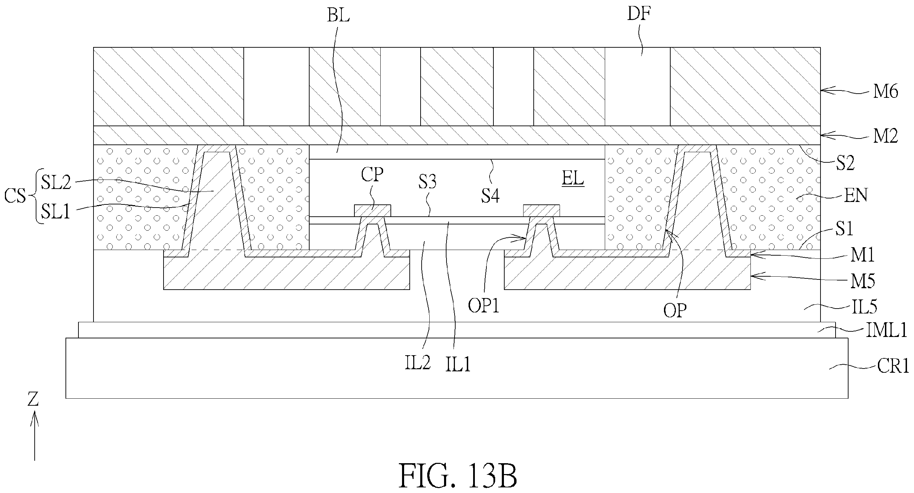

As shown in FIG. 13B, after the first circuit structure CL1 is formed, the intermediate layer IML1 and the carrier CR1 may be disposed on the insulating layer IL5, the formed structure may be flipped, and the carrier CR and the intermediate layer IML may be removed. Then, the patterned photo resist DF may be disposed on the second conductive layer M2, and the conductive layer M6 may be formed through the patterned photo resist DF. The detail of the manufacturing process of the conductive layer M6 may refer to the contents mentioned above, and will not be redundantly described.

As shown in FIG. 13C, after the conductive layer M6 is formed, the patterned photo resist DF may be removed, and the portion of the second conductive layer M2 exposed after the patterned photo resist DF is removed may be removed to pattern the second conductive layer M2. After that, the insulating layer IL6 may be disposed in the space (not labeled) formed by removing the patterned photo resist DF and a portion of the second conductive layer M2, and the bonding elements BE may be disposed corresponding to the conductive layer M6. The details of the manufacturing processes may refer to the contents mentioned above, and will not be redundantly described. After that, a cutting process may be performed, and the intermediate layer IML1 and the carrier CR1 may be removed to form the electronic device ED5. One of the main differences between the electronic device ED5 of the present embodiment and the electronic device ED1 shown in FIG. 5 is that the electronic device ED5 further includes the bonding layer BL located between the electronic element EL and the second conductive layer M2. It should be noted that the manufacturing method of the electronic device ED5 mentioned above is exemplary, and the present disclosure is not limited thereto.

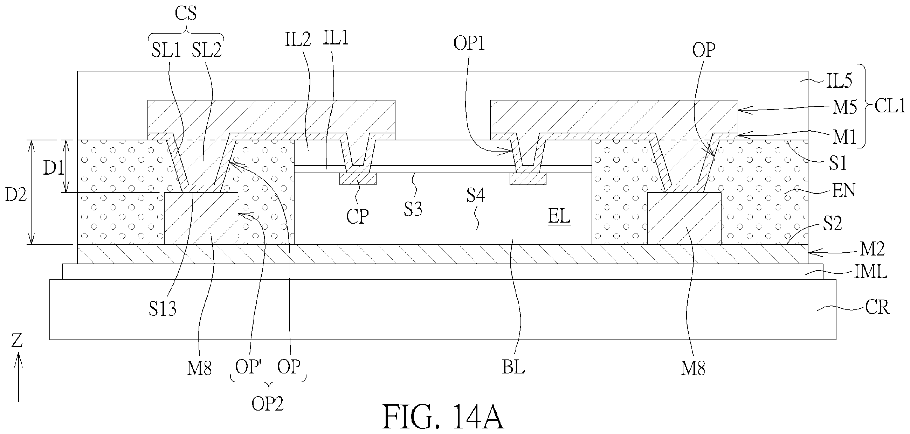

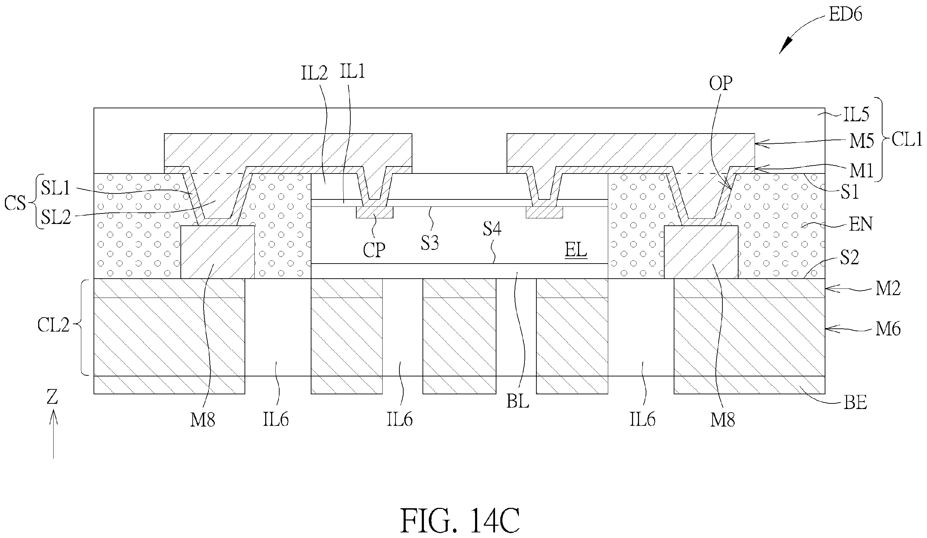

Referring to FIG. 14A to FIG. 14C, FIG. 14A to FIG. 14C schematically illustrate the manufacturing process of an electronic device according to a seventh embodiment of the present disclosure. The structure shown in FIG. 14C may be an embodiment of the electronic device ED6 of the present embodiment, but the present embodiment is not limited thereto. As shown in FIG. 14A, the manufacturing method of the electronic device ED6 may include adhering the second conductive layer M2 to the carrier CR through the intermediate layer IML and adhering the electronic element EL to the second conductive layer M2 through the bonding layer BL, but not limited thereto. In some embodiments, the electronic element EL may directly be disposed on the second conductive layer M2. After that, the first insulating layer IL1 and the second insulating layer IL2 may be disposed on the electronic element EL.

According to the present embodiment, the manufacturing method of the electronic device ED6 may further include disposing the conductive layer M8 on the second conductive layer M2, wherein the conductive layer M8 may contact the second conductive layer M2, thereby being electrically connected to the second conductive layer M2. In the present embodiment, the conductive layer M8 may serve as the alignment mark of the electronic element EL. Specifically, in the present embodiment, the conductive layer M8 may be disposed on the second conductive layer M2 at first, and then the electronic element EL is disposed on the second conductive layer M2. In the normal direction of the carrier CR, the conductive layer M8 may not overlap the electronic element EL. In such condition, the conductive layer M8 disposed on the second conductive layer M2 may help to position the electronic element EL, thereby reducing the possibility that the electronic element EL deviates from a predetermined disposition position. In addition, according to the present embodiment, the conductive layer M8 may overlap the openings OP of the encapsulation layer EN formed in the subsequent process in the normal direction of the carrier CR. After the conductive layer M8, the electronic element EL, the first insulating layer IL1 and the second insulating layer IL2 are formed, the encapsulation layer EN may be formed. The bottom surface S2 of the encapsulation layer EN may contact the second conductive layer M2, and the top surface S1 of the encapsulation layer EN may be aligned with the surface of the second insulating layer IL2 opposite to the first insulating layer IL1. For example, the encapsulation layer EN covering the electronic element EL, the first insulating layer IL1 and the second insulating layer IL2 may be disposed on the carrier CR at first. After that, a grinding process may be performed on the encapsulation layer EN through the grinding tool GM, such that the surface of the second insulating layer IL2 may be exposed. In the present embodiment, the encapsulation layer EN may cover the conductive layer M8, that is, the top surface S 1 of the encapsulation layer EN may be higher than the surface S13 of the conductive layer M8 opposite to the second conductive layer M2.

As shown in FIG. 14A, after the encapsulation layer EN is formed, the openings OP of the encapsulation layer EN, the openings OP1 exposing the conductive pads CP, the connecting structures CS and the first circuit structure CL1 may be formed. The details of the manufacturing processes thereof may refer to FIG. 7A and related contents mentioned above, and will not be redundantly described. According to the present embodiment, since the conductive layer M8 may overlap the openings OP of the encapsulation layer EN formed in the subsequent process in the normal direction of the carrier CR, at least a portion of the surface S13 of the conductive layer M8 may be exposed after removing a portion of the encapsulation layer EN to form the openings OP. In such condition, the first conductive layer M1 may extend into the openings OP and contact the surface S13 of the conductive layer M8, or in other words, the first sub layers SL1 of the connecting structures CS may contact the surface S13 of the conductive layer M8. Therefore, the connecting structures CS may be electrically connected to the conductive layer M8. According to the present embodiment, since the conductive layer M8 is formed on the second conductive layer M2 before the openings OP are formed, the depth of the openings OP may be lower than the thickness of the encapsulation layer EN. For example, the depth D1 of the opening OP may be lower than the thickness D2 of the encapsulation layer EN. Therefore, the difficulty of forming the connecting structures CS in the openings OP may be reduced. Specifically, the depth D1 of the opening OP may be reduced through the disposition of the conductive layer M8, thereby reducing the possibility that the connecting structures CS (for example, the second sub layers SL2) may not be effectively filled into the openings OP due to the excessive great depth of the opening OP. In addition, since the depth D1 of the opening OP may be reduced through the disposition of the conductive layer M8, the difference between the depth D1 of the opening OP and the depth of the opening OP1 may be reduced. In such condition, the second sub layers SL2 of the connecting structures CS and the conductive layer M5 may be formed at the same time. For example, the second sub layers SL2 and the conductive layer M5 may be formed through an electroplating process, but not limited thereto. It should be noted that the conductive layer M8 may be regarded to be disposed in an opening OP' of the encapsulation layer EN in the present embodiment, and the opening OP and the opening OP' may compose an opening OP2, wherein the opening OP2 may be connected between the top surface S 1 and the bottom surface S2 of the encapsulation layer EN.

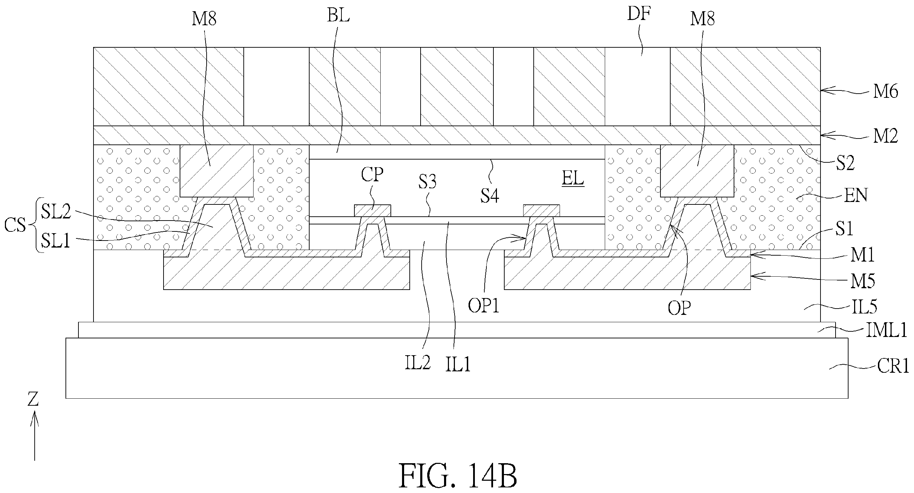

After that, as shown in FIG. 14B, after the first circuit structure CL1 is formed, the intermediate layer IML1 and the carrier CR1 may be disposed on the insulating layer IL5, the formed structure may be flipped, and the carrier CR and the intermediate layer IML may be removed. After that, the patterned photo resist DF may be disposed on the second conductive layer M2, and the conductive layer M6 may be formed through the patterned photo resist DF. The detail of the manufacturing process of the conductive layer M6 may refer to the contents mentioned above, and will not be redundantly described.

As shown in FIG. 14C, after the conductive layer M6 is formed, the patterned photo resist DF may be removed, and the portion of the second conductive layer M2 exposed after the patterned photo resist DF is removed may be removed to pattern the second conducive layer M2. Then, the insulating layer IL6 may be disposed in the spacing (not labeled) formed by removing the patterned photo resist DF and a portion of the second conductive layer M2, and the bonding elements BE may be disposed corresponding to the conductive layer M6. The details of the above-mentioned processes may refer to the contents mentioned above, and will not be redundantly described. After that, a cutting process may be performed, and the intermediate layer IML1 and the carrier CR1 may be removed, thereby forming the electronic device ED6.

According to the present embodiment, the electronic device ED6 may include the conductive layer M8 in contact with the second conductive layer M2, wherein the conductive layer M8 may overlap the openings OP in the normal direction of the electronic device ED6. The electronic element EL may be electrically connected to the second circuit structure CL2 through the first circuit structure CL1, the connecting structures CS in the openings OP and the conductive layer M8, thereby being electrically connected to the external electronic unit.

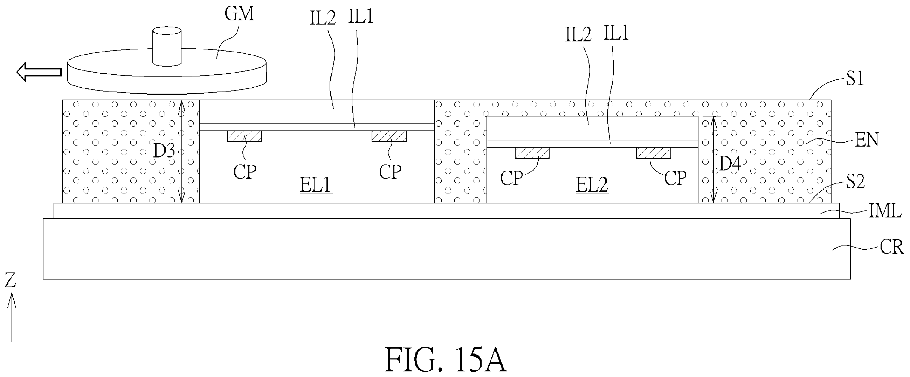

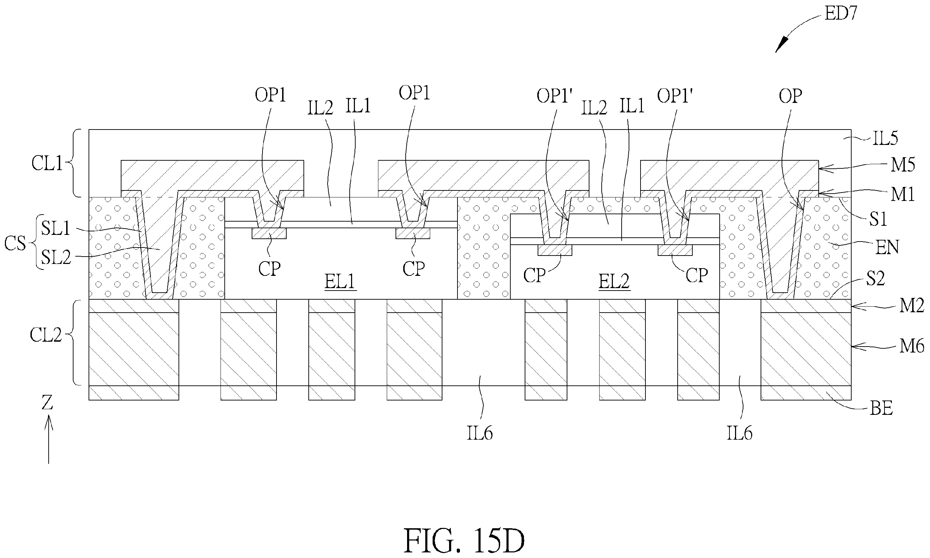

Referring to FIG. 15A to FIG. 15D, FIG. 15A to FIG. 15D schematically illustrate the manufacturing process of an electronic device according to an eighth embodiment of the present disclosure. The structure shown in FIG. 15D is an embodiment of the electronic device ED7 of the present embodiment, but the present embodiment is not limited thereto. The electronic device ED7 of the present embodiment may include a plurality of electronic elements EL. For example, as shown in FIG. 15D, the electronic device ED7 may include two electronic elements EL, but not limited thereto. As shown in FIG. 15A, the manufacturing method of the electronic device ED7 may include adhering the electronic element EL1 and the electronic element EL2 to the carrier CR through the intermediate layer IML at first, and then the first insulating layers IL1 and the second insulating layers IL2 may respectively be disposed on the electronic element EL1 and the electronic element EL2. After that, the encapsulation layer EN surrounding the electronic element EL1, the electronic element EL2, the first insulating layer IL1 and the second insulating layer IL2 may be formed. In the present embodiment, the height of the electronic element EL1 and the height of the electronic element EL2 may be different, but not limited thereto. In such condition, the encapsulation layer EN may expose the surface of the second insulating layer IL2 on one of the electronic element EL1 and the electronic element EL2 with a greater height. For example, the encapsulation layer EN covering the electronic element EL1, the electronic element EL2, the first insulating layer IL1 and the second insulating layer IL2 may be disposed on the carrier CR at first, wherein the height D3 of the electronic element EL1 may be greater than the height D4 of the electronic element EL2. After that, a grinding process may be performed on the encapsulation layer EN through the grinding tool GM, such that the surface of the second insulating layer IL2 disposed on the electronic element EL1 may be exposed. In such condition, the top surface S 1 of the encapsulation layer EN may be aligned with the surface of the second insulating layer IL2 on the electronic element EL1.

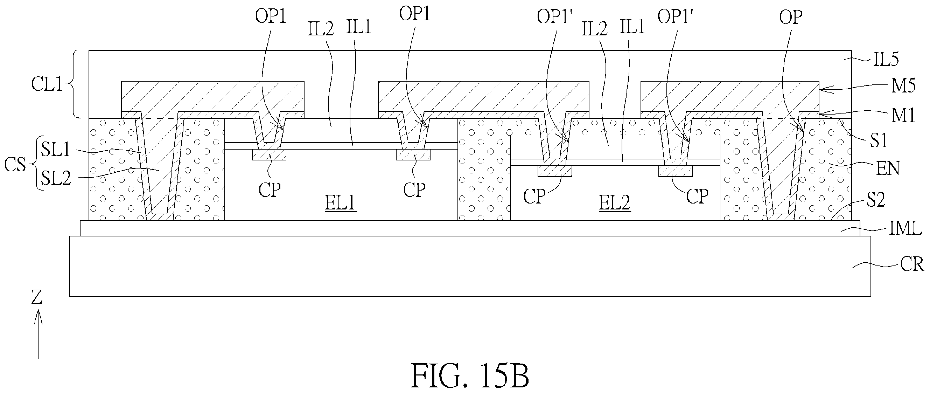

After that, as shown in FIG. 15B, after the encapsulation layer EN is formed, the openings OP in the encapsulation layer EN, the openings OP1 exposing the conductive pads CP of the electronic element EL1, the openings OP1' exposing the conductive pads CP of the electronic element EL2, the connecting structures CS and the first circuit structure CL1 may be formed. In the present embodiment, since the second insulating layer IL2 on the electronic element EL2 may be covered by the encapsulation layer EN, the openings OP1' may be formed by removing a portion of the encapsulation layer EN, a portion of the first insulating layer IL1 and a portion of the second insulating layer IL2. The detail of the above-mentioned process may refer to FIG. 7A and related contents mentioned above, and will not be redundantly described.

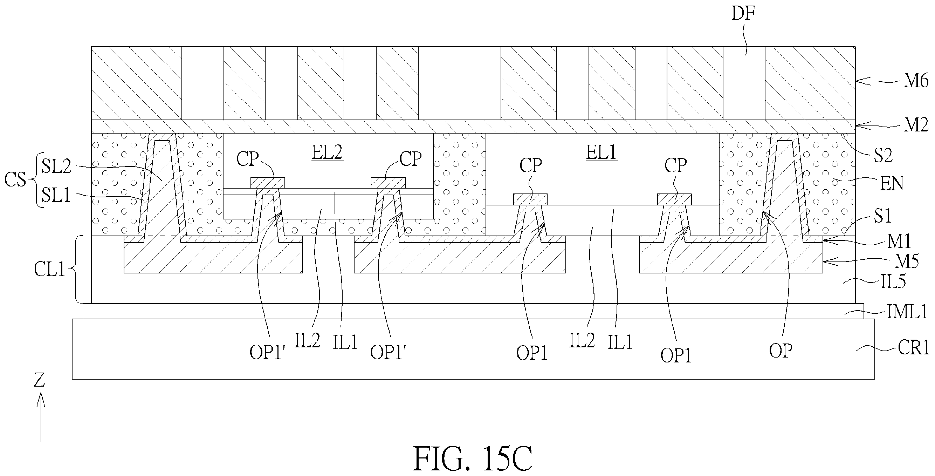

As shown in FIG. 15C, after the first circuit structure CL1 is formed, the intermediate layer IML1 and the carrier CR1 may be disposed on the insulating layer IL5, the formed structure may be flipped, and the carrier CR and the intermediate layer IML may be removed. After that, the second conductive layer M2 may be formed on the bottom surface S2 of the encapsulation layer EN, the patterned photo resist DF may be disposed on the second conductive layer M2, and the conductive layer M6 may be formed through the patterned photo resist DF. The details of the above-mentioned processes may refer to the related contents mentioned above, and will not be redundantly described.

As shown in FIG. 15D, after the conductive layer M6 is formed, the patterned photo resist DF may be removed, and the portion of the second conductive layer M2 exposed after the patterned photo resist DF is removed may be removed to pattern the second conductive layer M2. After that, the insulating layer IL6 may be disposed in the space (not labeled) formed by removing the patterned photo resist DF and a portion of the second conductive layer M2, and the bonding elements BE may be disposed corresponding to the conductive layer M6. The details of the above-mentioned processes may refer to the contents mentioned above, and will not be redundantly described. After that, a cutting process may be performed, and the intermediate layer IML1 and the carrier CR1 may be removed, thereby forming the electronic device ED7. It should be noted that the structures of the first circuit structure CL1 and the second circuit structure CL2 of the electronic device ED7 shown in FIG. 15D are exemplary, and the present disclosure is not limited thereto.

In summary, an electronic device is provided by the present disclosure, wherein the electronic device includes an electronic element, an encapsulation layer surrounding the electronic element and a first circuit structure and a second circuit structure respectively disposed at two sides of the encapsulation layer. The encapsulation layer includes openings, and the first circuit structure may be electrically connected to the second circuit structure through the openings. Therefore, the electronic element may be electrically connected to an external electronic unit through the first circuit structure and the second circuit structure. Compared with the traditional quad flat no leads package structures, the electronic device of the present disclosure may not include the lead frame or not formed through wire bonding process, and therefore, the production cost of the electronic device of the present disclosure may be reduced, or the thickness of the electronic device of the present disclosure may be lower.

For those skilled in the art, the technical features disclosed in the aforementioned embodiments can be replaced or recombined with one another to constitute another embodiment without departing from the spirit of the present disclosure.

## Claims

1. An electronic device (ED), **characterized by** comprising:
at least one electronic element (EL);
an encapsulation layer (EN) surrounding the at least one electronic element (EL), wherein the encapsulation layer (EN) has a top surface (S1), a bottom surface (S2) and at least one opening (OP), and a sidewall (SW) of the at least one opening (OP) connects the top surface (S1) and the bottom surface (S2);
a first circuit structure (CL1) disposed at the top surface (S1) of the encapsulation layer (EN);
a second circuit structure (CL2) disposed at the bottom surface (S2) of the encapsulation layer (EN); and
a connecting structure (CS) disposed in the at least one opening (OP), wherein the at least one electronic element (EL) is electrically connected to the second circuit structure (CL2) through the first circuit structure (CL1) and the connecting structure (CS),
wherein the connecting structure (CS) includes a first sub layer (SL1) and a second sub layer (SL2), the first sub layer (SL1) is located between the encapsulation layer (EN) and the second sub layer (SL2), and the first sub layer (SL1) covers the sidewall (SW) of the at least one opening (OP).

2. The electronic device (ED) of claim 1, **characterized by** further comprising a first insulating layer (IL1) disposed on a top surface (S3) of the at least one electronic element (EL).

3. The electronic device (ED) of claim 2, **characterized by** further comprising a second insulating layer (IL2) disposed on the first insulating layer (IL1), wherein a thickness (T2) of the second insulating layer (IL2) is greater than a thickness (T1) of the first insulating layer (IL1).

4. The electronic device (ED) of claim 3, **characterized in that** the thickness (T1) of the first insulating layer (IL1) ranges from 0.5 micrometers to 3 micrometers.

5. The electronic device (ED) of claim 3, **characterized in that** the thickness (T2) of the second insulating layer (IL2) ranges from 5 micrometers to 25 micrometers.

6. The electronic device (ED) of any one of claim 1 to claim 5, **characterized by** further comprising a bonding element (BE) disposed at a surface of the second circuit structure (CL2) opposite to the at least one electronic element (EL).

7. The electronic device (ED) of claim 6, **characterized in that** the bonding element (BE) is disposed misaligned with the at least one opening (OP) in a top view direction of the electronic device (ED).

8. The electronic device (ED) of any one of claim 1 to claim 7, **characterized in that** the first circuit structure (CL1) comprises a first conductive layer (M1) contacting the top surface (S1) of the encapsulation layer (EN), and the second circuit structure (CL2) comprises a second conductive layer (M2) contacting the bottom surface (S2) of the encapsulation layer (EN).

9. The electronic device (ED) of claim 8, **characterized in that** the first conductive layer (M1) and the second conductive layer (M2) are overlapped with the at least one opening (OP) of the encapsulation layer (EN) in a top view direction of the electronic device (ED).

10. The electronic device (ED) of claim 8 or claim 9, **characterized in that** one of the first conductive layer (M1) and the second conductive layer (M2) is disposed in the at least one opening (OP) of the encapsulation layer (EN) and contacts another one of the first conductive layer (M1) and the second conductive layer (M2).

11. An electronic device (ED), **characterized by** comprising:
at least one electronic element (EL);
an encapsulation layer (EN) surrounding the at least one electronic element (EL), wherein the encapsulation layer (EN) has a top surface (S1), a bottom surface (S2) and at least one opening (OP), and a sidewall (SW) of the at least one opening (OP) connects the top surface (S1) and the bottom surface (S2);
a first circuit structure (CL1) disposed at the top surface (S1) of the encapsulation layer (EN);
a second circuit structure (CL2) disposed at the bottom surface (S2) of the encapsulation layer (EN); and
a connecting structure (CS) disposed in the at least one opening (OP),
wherein the at least one electronic element (EL) is electrically connected to the second circuit structure (CL2) through the first circuit structure (CL1) and the connecting structure (CS).

12. The electronic device (ED) of claim 11, **characterized by** further comprising:
a first insulating layer (IL1) disposed on a top surface (S3) of the at least one electronic element (EL); and
a second insulating layer (IL2) disposed on the first insulating layer (IL1),
wherein a thickness (T2) of the second insulating layer (IL2) is greater than a thickness (T1) of the first insulating layer (IL1).

13. The electronic device (ED) of claim 12, **characterized in that** the thickness (T1) of the first insulating layer (IL1) ranges from 0.5 micrometers to 3 micrometers.

14. The electronic device (ED) of claim 12, **characterized in that** the thickness (T2) of the second insulating layer (IL2) ranges from 5 micrometers to 25 micrometers.

15. The electronic device (ED) of any one of claim 11 to claim 14, **characterized by** further comprising a bonding element (BE) disposed at a surface of the second circuit structure (CL2) opposite to the at least one electronic element (EL).
